(19) Europäisches Patentamt
European Patent Office
Office européen des brevets

(11) EP 4 270 448 A1

(12) **EUROPEAN PATENT APPLICATION**
published in accordance with Art. 153(4) EPC

(43) Date of publication:
**01.11.2023 Bulletin 2023/44**

(21) Application number: **21910480.9**

(22) Date of filing: **14.12.2021**

(51) International Patent Classification (IPC):
***H01L 21/027*** *(2006.01)* ***B29C 59/02*** *(2006.01)*

(52) Cooperative Patent Classification (CPC):
**B29C 59/02; H01L 21/027**

(86) International application number:
**PCT/JP2021/046063**

(87) International publication number:
**WO 2022/138331 (30.06.2022 Gazette 2022/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.12.2020 JP 2020212772**
**07.12.2021 JP 2021198701**

(71) Applicant: **CANON KABUSHIKI KAISHA**
**Tokyo 146-8501 (JP)**

(72) Inventors:
- **ITO, Yuto**
**Tokyo 146-8501 (JP)**
- **ITO, Toshiki**
**Tokyo 146-8501 (JP)**
- **KAWATA, Isao**
**Tokyo 146-8501 (JP)**

(74) Representative: **TBK**
**Bavariaring 4-6**
**80336 München (DE)**

(54) **FILM FORMATION METHOD AND ARTICLE MANUFACTURING METHOD**

(57) A film forming method of forming a film made of a curable composition, includes an arranging step of arranging the curable composition on an underlayer of a substrate including a base member and the underlayer arranged on the base member, a contact step of bringing the curable composition and a mold into contact with each other after the arranging step, a curing step of curing the curable composition after the contact step, and a separation step of separating the curable composition and the mold after the curing step, wherein a gas filling a space between the underlayer and the mold exists in the contact step, and a solubility coefficient of the gas with respect to the underlayer is 0.5 kg/$m^3$•atm or more and 10 kg/$m^3$•atm or less.

FIG. 1

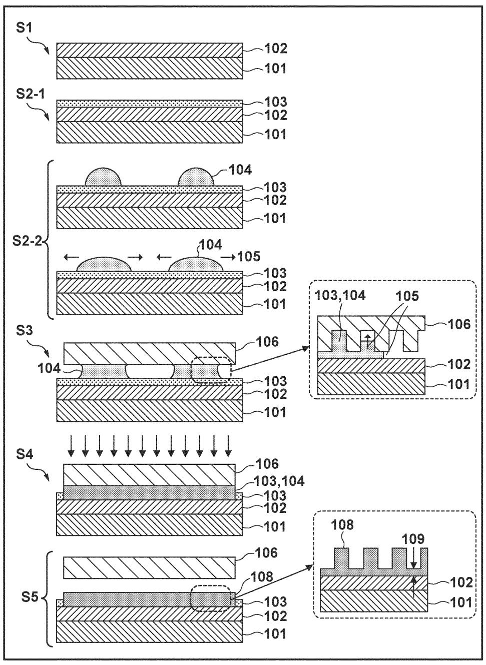


EP 4 270 448 A1

**Description**

TECHNICAL FIELD

The present invention relates to a film forming method and an article manufacturing method.

BACKGROUND ART

A demand for miniaturization of semiconductor devices and MEMS is increasing, and a photonanoimprint technique is attracting attention as a microfabrication technique. In this photonanoimprint technique, a mold on the surface of which a fine pattern of concave and convex portions is formed is pressed against a substrate (wafer), and the curable composition is cured in this state, thereby transferring the pattern having concave and convex portions of the mold onto the cured film of the curable composition, and forming the pattern on the substrate. The photonanoimprint technique can form a fine structure on the order of a few nanometers on a substrate.

An example of a pattern forming method using the photonanoimprint technique will be explained below. First, a liquid curable composition is discretely dropped in a pattern formation region on a substrate. The droplets of the curable composition dropped in the pattern formation region spread on the substrate. This phenomenon can be called prespread. Then, a mold having a pattern is pressed against the curable composition on the substrate.
Consequently, the droplets of the curable composition spread parallel to the substrate to the whole area of the gap between the substrate and the mold by the capillary action. This phenomenon can be called spread. The curable composition is also filled in the concave portions of the pattern of the mold by the capillary action. This filling phenomenon can be called filling. The time until the completion of spread and filling can be called a filling time. After the filling of the curable composition is completed, the curable composition is irradiated with light and cured. After that, the mold is removed from the cured curable composition. By performing these steps, the mold pattern is transferred to the curable composition on the substrate, and a pattern of the curable composition is formed.

To accurately form a fine pattern with high aspect ratio, methods such as a multilayered curable composition process and an inversion process can be used. In these methods, after a pattern of a curable composition is transferred once to a layer having a high etching resistance (a high-etching-resistance layer) different from the curable composition, a target underlayer can be processed by using the high-etching-resistance layer as an etching mask. As the material of the high-etching-resistance layer, an organic material or a silicon-based material can be used. As the organic material, SOC (Spin On Carbon) containing carbon as a main component is sometimes used (PTL 1).

The high-etching-resistance layer is also used in pattern formation using nanoimprint. PTL 2 discloses an inversion process using nanoimprint, and uses SOC as the high-etching-resistance layer. In this nanoimprint process to be performed on SOC, it is possible to coat the SOC with an adhesive layer material for nanoimprint, and perform nanoimprint on the material (PTL 3).

A photolithography step of fabricating a semiconductor device requires planarization of a substrate as well. For example, in an extreme ultraviolet exposure technique (EUV) as a photolithography technique attracting attention in recent years, the depth of focus at which a projected image is formed decreases as miniaturization advances, so the unevenness on the substrate surface to be coated with a curable composition must be decreased to 4 nm or less. Flatness equivalent to that of EUV is required in a nanoimprint lithography (NIL) technique as another photolithography technique as well, in order to improve the filling properties and the line width accuracy (NPL 1). As the planarization technique, a technique is known in which droplets of a liquid curable composition are discretely dropped on a substrate having concave and convex portions by an amount corresponding to the concave and convex portions, and a flat surface is obtained by curing the curable composition in a state in which a mold having a flat surface is pressed against the curable composition (PTLs 4 and 5).

In the abovementioned pattern formation techniques and planarization technique, a high throughput is required to improve the productivity, and spread and filling are steps requiring the longest time. It is known that in the photonanoimprint technique using SOC, the filling rate improves by using helium or air as an ambient gas (NPL 2).

CITATION LIST

PATENT LITERATURE

PTL 1: Japanese Patent No. 5065058
PTL 2: Japanese Patent Laid-Open No. 2016-162862
PTL 3: Japanese Patent No. 5827180

PTL 4: Japanese Patent Laid-Open No. 2019-140394
PTL 5: US-2020-0286740
PTL 6: Japanese Patent Laid-Open No. 2009-503139

NON PATENT LITERATURE

NPL 1: N. Shiraishi/Int. J. Microgravity Sci. No. 31 Supplement 2014 (S5-S12)
NPL 2: Proc. SPIE 11324-11 (2020)
NPL 3: Susumu Okazaki, "Basis of Computer Simulation", KAGAKUDOJIN (2000)
NPL 4: B. H. Besler, K. M. Merz Jr., and P. A. Kollman, J. Comp. Chem. 11, 431 (1990).
NPL 5: U. C. Singh and P. A. Kollman, J. Comp. Chem. 5, 129 (1984).

SUMMARY OF INVENTION

TECHNICAL PROBLEM

The present inventors have found the problem that when a layer in contact with a curable composition is thinned, the filling rate decreases in a helium atmosphere or an air atmosphere. Therefore, it is an object of the present invention to provide a technique advantageous in rapidly completing filling even when a layer in contact with a curable composition is thinned.

SOLUTION TO PROBLEM

According to one aspect of the present invention, there is provided a film forming method of forming a film made of a curable composition, and the film forming method includes an arranging step of arranging the curable composition on an underlayer of a substrate including a base member and the underlayer arranged on the base member, a contact step of bringing the curable composition and a mold into contact with each other after the arranging step, a curing step of curing the curable composition after the contact step, and a separation step of separating the curable composition and the mold after the curing step, wherein a gas filling a space between the underlayer and the mold exists in the contact step, and a solubility coefficient of the gas with respect to the underlayer is 0.5 $kg/m^3$•atm or more and 10 $kg/m^3$•atm or less.

ADVANTAGEOUS EFFECTS OF INVENTION

According to the present invention, there is provided a technique advantageous in suppressing a decrease in filling rate even when a layer in contact with a curable composition is thinned.

BRIEF DESCRIPTION OF DRAWINGS

The accompanying drawings, which are incorporated in and constitute a part of the specification, illustrate embodiments of the invention and, together with the description, serve to explain principles of the invention.

Fig. 1 is a schematic sectional view showing a film forming method according to the first embodiment;
Fig. 2 is a schematic sectional view showing a case in which a curable composition (A1) is omitted in the film forming method according to the first embodiment;
Fig. 3 is a schematic sectional view showing a film forming method according to the second embodiment;
Fig. 4 is a view for explaining an example of a theoretical calculation;
Fig. 5A is a view for explaining an article manufacturing method;
Fig. 5B is a view for explaining the article manufacturing method;
Fig. 5C is a view for explaining the article manufacturing method;
Fig. 5D is a view for explaining the article manufacturing method;
Fig. 5E is a view for explaining the article manufacturing method;
Fig. 5F is a view for explaining the article manufacturing method;
Fig. 6A is a view for explaining an article manufacturing method;
Fig. 6B is a view for explaining the article manufacturing method;
Fig. 6C is a view for explaining the article manufacturing method; and

Fig. 6D is a view for explaining the article manufacturing method.

## DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

### <<First Embodiment>>

### [Curable Composition]

Curable compositions (A1) and (A2) according to this embodiment are compositions containing at least a component (a) as a polymerizable compound. The curable compositions according to this embodiment can further contain a component (b) as a photopolymerization initiator, a nonpolymerizable compound (c), and a component (d) as a solvent.

In the present invention, the curable composition (A1) can be omitted.

In this specification, a cured film means a film cured by polymerizing a curable composition on a substrate. Note that the shape of the cured film is not particularly limited, so the film can have a pattern shape on the surface.

### <Component (a): Polymerizable Compound>

The component (a) is a polymerizable compound. In this specification, the polymerizable compound is a compound that reacts with a polymerizing factor (for example, a radical) generated from a photopolymerization initiator (the component (b)), and forms a film made of a polymer compound by a chain reaction (polymerization reaction).

An example of the polymerizable compound as described above is a radical polymerizable compound. The polymerizable compound as the component (a) can be formed by only one type of a polymerizable compound, and can also be formed by a plurality of types of polymerizable compounds.

The radical polymerizable compound is preferably a compound having one or more acryloyl groups or methacryloyl groups, that is, a (meth)acrylic compound. Accordingly, the curable composition according to this embodiment preferably contains a (meth)acrylic compound as the component (a). More preferably, a main component of the component (a) is a (meth)acrylic compound, and most preferably, the curable composition is a (math)acrylic compound. Note that "a main component of the component (a) is a (meth)acrylic compound" described herein means that 90 mass% or more of the component (a) is a (meth)acrylic compound.

When the radical polymerizable compound is formed by a plurality of types of compounds having one or more acryloyl groups or methacryloyl groups, the radical polymerizable compound preferably contains a monofunctional (meth)acrylic monomer and a polyfunctional (meth)acrylic monomer. This is so because a cured film having a high mechanical strength can be obtained by combining the monofunctional (meth)acrylic monomer and the polyfunctional (meth)acrylic monomer.

Examples of the monofunctional (meth)acrylic compound having one acryloyl group or methacryloyl group are as follows, but the compound is not limited to these examples.

Phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxyethyl (meth)acrylate, 4-phenylphenoxyethyl (meth)acrylate, 3-(2-phenylphenyl)-2-hydroxypropyl (meth)acrylate, (meth)acrylate of EO-modified p-cumylphenol, 2-bromophenoxyethyl (meth)acrylate, 2,4-dibromophenoxyethyl (meth)acrylate, 2,4,6-tribromophenoxyethyl (meth)acrylate, EO-modified phenoxy (meth)acrylate, PO-modified phenoxy (meth)acrylate, polyoxyethylenenonylphenylether (meth)acrylate, isobornyl (meth)acrylate, 1-adamantyl (meth)acrylate, 2-methyl-2-adamantyl (meth)acrylate, 2-ethyl-2-adamantyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, 4-butylcyclohexyl (meth)acrylate, acryloylmorpholine, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, isostearyl (meth)acrylate, benzyl (meth)acrylate, tetrahydrofurfuryl (meth)acrylate, butoxyethyl (meth)acrylate, ethoxydiethyleneglycol (meth)acrylate, polyethyleneglycol mono(meth)acrylate, polypropyleneglycol mono(meth)acrylate, methoxyethyleneglycol (meth)acrylate, ethoxyethyl (meth)acrylate, methoxypolyethyleneglycol (meth)acrylate, methoxypolypropyleneglycol (meth)acrylate, diacetone (meth)acrylamide, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, 7-amino-3,7-dimethyloctyl (meth)acrylate, N,N-diethyl (meth)acrylamide, and N,N-dimethylaminopropyl (meth)acrylamide.

Examples of commercially available products of the abovementioned monofunctional (meth)acrylic compounds are as follows, but the products are not limited to these examples.

ARONIX® M101, M102, M110, M111, M113, M117, M5700, TO-1317, M120, M150, and M156 (manufactured by TOAGOSEI); MEDOL10, MIBDOL10, CHDOL10, MMDOL30, MEDOL30, MIBDOL30, CHDOL30, LA, IBXA, 2-MTA, HPA, and Viscoat #150, #155, #158, #190, #192, #193, #220, #2000, #2100, and #2150 (manufactured by OSAKA ORGANIC CHEMICAL INDUSTRY); Light Acrylate BO-A, EC-A, DMP-A, THF-A, HOP-A, HOA-MPE, HOA-MPL, PO-A, P-200A, NP-4EA, NP-8EA, and Epoxy Ester M-600A (manufactured by KYOEISHA CHEMICAL); KAYARAD® TC110S, R-564, and R-128H (manufactured by NIPPON KAYAKU); NK Ester AMP-10G and AMP-20G (manufactured by SHIN-NAKAMURA CHEMICAL); FA-511A, 512A, and 513A (manufactured by Hitachi Chemical); PHE, CEA, PHE-2, PHE-4, BR-31, BR-31M, and BR-32 (manufactured by DKS); VP (manufactured by BASF); and ACMO, DMAA, and DMAPAA (manufactured by Kohjin).

Examples of a polyfunctional (meth)acrylic compound having two or more acryloyl groups or methacryloyl groups are as follows, but the compound is not limited to these examples.

Trimethylolpropane di(meth)acrylate, trimethylolpropane tri(meth)acrylate, EO-modified trimethylolpropane tri(meth)acrylate, PO-modified trimethylolpropane tri(meth)acrylate, EO- and PO-modified trimethylolpropane tri(meth)acrylate, dimethylol tricyclodecane di(meth)acrylate, pentaerythritol tri(meth)acrylate, pentaerythritol tetra(meth)acrylate, ethylene glycol di(meth)acrylate, tetraethylene glycol di(meth)acrylate, polyethylene glycol di(meth)acrylate, polypropylene glycol di(meth)acrylate, 1,4-butanediol di(meth)acrylate, 1,6-hexanediol di(meth)acrylate, neopentyl glycol di(meth)acrylate, 1,9-nonanediol di(meth)acrylate, 1,10-decanediol di(meth)acrylate, 1,3-adamantanedimethanol di(meth)acrylate, tris(2-hydoxyethyl)isocyanurate tri(meth)acrylate, tris(acryloyloxy)isocyanurate, bis(hydroxymethyl)tri cyclodecane di(meth)acrylate, dipentaerythritol penta(meth)acrylate, dipentaerythritol hexa(meth)acrylate, EO-modified 2,2-bis(4-((meth)acryloxy)phenyl)propane, PO-modified 2,2-bis(4-((meth)acryloxy)phenyl)propane, EO- and PO-modified 2,2-bis(4-((meth)acryloxy)phenyl)propane.

Examples of commercially available products of the abovementioned polyfunctional (meth)acrylic compounds are as follows, but the products are not limited to these examples.

Yupimer® UV SA1002 and SA2007 (manufactured by Mitsubishi Chemical); Viscoat #195, #230, #215, #260, #335HP, #295, #300, #360, #700, GPT, and 3PA (manufactured by OSAKA ORGANIC CHEMICAL INDUSTRY); Light Acrylate 4EG-A, 9EG-A, NP-A, DCP-A, BP-4EA, BP-4PA, TMP-A, PE-3A, PE-4A, and DPE-6A (manufactured by KYOEISHA CHEMICAL); KAYARAD® PET-30, TMPTA, R-604, DPHA, DPCA-20, -30, -60, and -120, HX-620, D-310, and D-330 (manufactured by NIPPON KAYAKU); ARONIX® M208, M210, M215, M220, M240, M305, M309, M310, M315, M325, and M400 (manufactured by TOAGOSEI); and Ripoxy® VR-77, VR-60, and VR-90 (manufactured by Showa Highpolymer).

Note that in the above-described compounds, (meth)acrylate means acrylate or methacrylate having an alcohol residue equal to acrylate. A (meth)acryloyl group means an acryloyl group or a methacryloyl group having an alcohol residue equal to the acryloyl group. EO indicates ethylene oxide, and an EO-modified compound A indicates a compound in which a (meth)acrylic acid residue and an alcohol residue of a compound A bond via the block structure of an ethylene oxide group. Also, PO indicates a propylene oxide, and a PO-modified compound B indicates a compound in which a (meth)acrylic acid residue and an alcohol residue of a compound B bond via the block structure of a propylene oxide group.

<Component (b): Photopolymerization Initiator>

The component (b) is a photopolymerization initiator. In this specification, the photopolymerization initiator is a compound that senses light having a predetermined wavelength and generates the polymerization factor (radical) described earlier. More specifically, the photopolymerization initiator is a polymerization initiator (radical generator) that generates a radical by light (infrared light, visible light, ultraviolet light, far-ultraviolet light, X-ray, a charged particle beam such as an electron beam, or radiation). The component (b) can be formed by only one type of a photopolymerization initiator, and can also be formed by a plurality of types of photopolymerization initiators.

Examples of the radical generator are as follows, but the radical generator is not limited to these examples.

2,4,5-triarylimidazole dimers that can have substituent groups, such as a 2-(o-chlorophenyl)-4,5-diphenylimidazole dimer, a 2-(o-chlorophenyl)-4,5-di(methoxyphenyl)imidazole dimer, a 2-(o-fluorophenyl)-4,5-diphenylimidazole dimer, and a 2-(o- or p-methoxyphenyl)-4,5-diphenylimidazole dimer; benzophenone derivatives such as benzophenone, N,N'-tetramethyl-4,4'-diaminobenzophenone (Michiler's ketone), N,N'-tetraethyl-4,4'-diaminobenzophenone, 4-methoxy-4'-dimethylaminobenzophenone, 4-chlorobenzophenone, 4,4'-dimethoxybenzophenone, and 4,4'-diaminobenzophenone; α-amino aromatic ketone derivatives such as 2-benzyl-2-dimethylamino-1-(4-morpholinophenyl)-butanone-1,2-methyl-1-[4-(methylthio)phenyl]-2-morpholino-propane-1-one; quinones such as 2-ethylanthraquinone, phenanthrenequinone, 2-t-butylanthraquinone, octamethylanthraquinone, 1,2-benzanthraquinone, 2,3-benzanthraquinone, 2-phenylanthraquinone, 2,3-diphenylamthraquinone, 1-chloroanthraquinone, 2-methylanthraquinone, 1,4-naphtoquinone, 9,10-phenanthraquinone, 2-methyl-1,4-naphtoquinone, and 2,3-dimethylanthraquinone; benzoin ether derivatives such as benzoin methyl ether, benzoin ethyl ether, and benzoin phenyl ether; benzoin derivatives such as benzoin, methyl benzoin, ethyl benzoin, and propyl benzoin; benzyl derivatives such as benzyldimethylketal; acridine derivatives such as 9-phenylacridine and 1,7-bis(9,9'-acrydinyl)heptane; N-phenylglycine derivatives such as N-phenylglycine; acetophenone derivatives such as acetophenone, 3-methylacetophenone, acetophenone benzylketal, 1-hydroxycylohexyl phenylketone, and 2,2-dimethoxy-2-phenyl acetophenone; thioxanthone derivatives such as thioxanthone, diethylthioxanthone, 2-isopropylthioxanthone, and 2-chlorothioxanthone; acylphosphine oxide derivatives such as 2,4,6-trimethylbenzoyldiphenylphosphine oxide, bis(2,4,6-trimethylbenzoyl)phenylphosphine oxide, and bis-(2,6-dimethoxybenzoyl)-2,4,4-trimethylpentylphosphine oxide; oxime ester derivatives such as 1,2-octanedione, 1-[4-(phenylthiol)-,2-(O-benzoyloxime)], ethanone, 1-[9-ethyl-6-(2-methylbenzoyl)-9H-carbazole-3-yl]-, and 1-(O-acetyloxime); and xanthone, fluorenone, benzaldehyde, fluorene, anthraquinone, triphenylamine, carbazole, 1-(4-isopropylphenyl)-2-hydroxy-2-methylprapane-1-one, and 2-hydroxy-2-methyl-1 -phenylpropane-1 -one.

Examples of commercially available products of the above-described radical generators are as follows, but the products are not limited to these examples.

Irgacure 184, 369, 651, 500, 819, 907, 784, and 2959, CGI-1700, -1750, and -1850, CG24-61, Darocur 1116 and 1173, Lucirin® TPO, LR8893, and LR8970 (manufactured by BASF), and Ubecryl P36 (manufactured by UCB).

Of the above-described radical generators, the component (b) is preferably an acylphosphine oxide-based polymerization initiator. Note that in the abovementioned examples, the acylphosphine oxide-based polymerization initiators are acylphosphine oxide compounds such as 2,4,6-trimethylbenzoyl diphenylphosphine oxide, bis(2,4,6-trimethylbenzoyl)phenylphosphine oxide, and bis(2,6-dimethoxybenzoyl)-2,4,4-trimethylpentylphosphine oxide.

In this embodiment, the curable composition (A1) preferably has practically no photoreactivity. For this purpose, the blending ratio of the component (b) in the curable composition (A1) is preferably less than 0.1 mass%, more preferably 0.01 mass% or less, and most preferably 0.001 mass% or less, with respect to the total of the component (a), the component (b), and the component (c) (to be described later), that is, the total mass of all the components except the solvent component (d). When the blending ratio of the component (b) is less than 0.1 mass%, the curable composition (A1) has practically no photoreactivity. Therefore, no photo-curing occurs due to leakage light, so a pattern having less unfilling defects can be obtained by a short filling time even in an adjacent shot. The curing reaction of the curable composition (A1) in the shot will be described later.

The blending ratio of the component (b) in the curable composition (A2) is preferably 0.1 mass% or more and 50 mass% or less, more preferably 0.1 mass% or more and 20 mass% or less, and further preferably 1 mass% or more and 20 mass% or less, with respect to the total of the component (a), the component (b), and the component (c) (to be described later), that is, the total mass of all the components except the solvent component (d). When the blending ratio of the component (b) is 0.1 mass% or more, the curing rate of the composition increases, so the reaction efficiency can be increased. When the blending ratio is 50 mass% or less, a cured film having a mechanical strength to some extent can be obtained.

<Component (c): Nonpolymerizable Compound>

In addition to the components (a) and (b) described above, the curable compositions (A1) and (A2) according to this embodiment can further contain a nonpolymerizable compound as the component (c) within a range that does not impair the effect of this embodiment, in accordance with various purposes. An example of the component (c) is a compound that does not contain a polymerizable functional group such as a (meth)acryloyl group, and does not have the ability to sense light having a predetermined wavelength and to generate the polymerization factor (radical) described previously. Examples of the nonpolymerizable compound are a sensitizer, a hydrogen donor, an internal mold release agent, an antioxidant, a polymer component, and other additives. The component (c) can contain a plurality of types of the above-described compounds.

The sensitizer is a compound that is properly added for the purpose of promoting the polymerization reaction and improving the reaction conversion rate. As the sensitizer, it is possible to use one type of a compound alone, or to use two or more types of compounds by mixing them.

An example of the sensitizer is a sensitizing dye. The sensitizing dye is a compound that is excited by absorbing light having a specific wavelength and has an interaction with a photopolymerization initiator as the component (b).

Note that the "interaction" herein described is, for example, energy transfer or electron transfer from the sensitizing dye in the excited state to the photopolymerization initiator as the component (b). Practical examples of the sensitizing dye are as follows, but the sensitizing dye is not limited to these examples. An anthracene derivative, an anthraquinone derivative, a pyrene derivative, a perylene derivative, a carbazole derivative, a benzophenone derivative,

a thioxanthone derivative, a xanthone derivative, a coumarin derivative, a phenothiazine derivative, a camphorquinone derivative, an acridinic dye, a thiopyrylium salt-based dye, a merocyanine-based dye, a quinoline-based dye, a styryl quinoline-based dye, a ketocoumarin-based dye, a thioxanthene-based dye, a xanthene-based dye, an oxonol-based dye, a cyanine-based dye, a rhodamine-based dye, and a pyrylium salt-based dye.

The hydrogen donor is a compound that reacts with an initiation radical generated from the photopolymerization initiator as the component (b) or a radical at a polymerization growth end, and generates a radical having higher reactivity. The hydrogen donor is preferably added when the photopolymerization initiator as the component (b) is a photo-radical generator.

Practical examples of the hydrogen donor as described above are as follows, but the hydrogen donor is not limited to these examples.

Amine compounds such as n-butylamine, di-n-butylamine, tri-n-butylphosphine, allylthiourea, s-benzylisothiuronium-p-toluenesulfinate, triethylamine, diethylaminoethyl methacrylate, triethylenetetramine, 4,4'-bis(dialkylamino)benzophenone, N,N-dimethylamino ethylester benzoate, N,N-dimethylamino isoamylester benzoate, pentyl-4-dimethylamino benzoate, triethanolamine, and N-phenylglycine; and mercapto compounds such as 2-mercapto-N-phenylbenzoimidazole and mercapto propionate ester. As the hydrogen donor, it is possible to use one type of a compound alone or to use two or more types of compounds by mixing them. The hydrogen donor can also have the function as a sensitizer.

An internal mold release agent can be added to the curable composition for the purpose of reducing the interface bonding force between a mold and the curable composition, that is, reducing the mold release force in a mold release step (to be described later). In this specification, "internal" means that the mold release agent is added to the curable composition in advance before a curable composition arranging step. As the internal mold release agent, it is possible to use surfactants such as a silicon-based surfactant, a fluorine-based surfactant, and a hydrocarbon-based surfactant. In this embodiment, however, the addition amount of the fluorine-based surfactant is limited as will be described later. Note that the internal mold release agent according to this embodiment is not polymerizable. It is possible to use one type of an internal mold release agent alone, or to use two or more types of internal mold release agents by mixing them.

The fluorine-based surfactant includes, for example, a polyalkylene oxide (for example, polyethylene oxide or polypropylene oxide) adduct of alcohol having a perfluoroalkyl group, and a polyalkylene oxide (for example, polyethylene oxide or polypropylene oxide) adduct of perfluoropolyether. Note that the fluorine-based surfactant can have a hydroxyl group, an alkoxy group, an alkyl group, an amino group, or a thiol group in a portion (for example, a terminal group) of the molecular structure. An example is pentadecaethyleneglycol mono1H,1H,2H,2H-perfluorooctylether.

It is also possible to use a commercially available product as the fluorine-based surfactant. Examples of the commercially available product of the fluorine-based surfactant are as follows. MEGAFACE® F-444, TF-2066, TF-2067, and TF-2068, and DEO-15 (abbreviation) (manufactured by DIC); Fluorad FC-430 and FC-431 (manufactured by Sumitomo 3M); Surflon® S-382 (manufactured by AGC); EFTOP EF-122A, 122B, 122C, EF-121, EF-126, EF-127, and MF-100 (manufactured by Tochem Products); PF-636, PF-6320, PF-656, and PF-6520 (manufactured by OMNOVA Solutions); UNIDYNE® DS-401, DS-403, and DS-451 (manufactured by DAIKIN); and FUTAGENT® 250, 251, 222F, and 208G (manufactured by NEOS).

The internal mold release agent can also be a hydrocarbon-based surfactant. The hydrocarbon-based surfactant includes an alkyl alcohol polyalkylene oxide adduct obtained by adding alkylene oxide having a carbon number of 2 to 4 to alkyl alcohol having a carbon number of 1 to 50, and polyalkylene oxide.

Examples of the alkyl alcohol polyalkylene oxide adduct are as follows. A methyl alcohol ethylene oxide adduct, a decyl alcohol ethylene oxide adduct, a lauryl alcohol ethylene oxide adduct, a cetyl alcohol ethylene oxide adduct, a stearyl alcohol ethylene oxide adduct, and a stearyl alcohol ethylene oxide/propylene oxide adduct. Note that the terminal group of the alkyl alcohol polyalkylene oxide adduct is not limited to a hydroxyl group that can be manufactured by simply adding polyalkylene oxide to alkyl alcohol. This hydroxyl group can also be substituted by another substituent group, for example, a polar functional group such as a carboxyl group, an amino group, a pyridyl group, a thiol group, or a silanol group, or a hydrophobic group such as an alkyl group or an alkoxy group.

Examples of polyalkylene oxide are as follows. Polyethylene glycol, polypropylene glycol, their mono or dimethyl ether, mono or dioctyl ether, mono or dinonyl ether, and mono or didecyl ether, monoadipate, monooleate, monostearate, and monosuccinate.

A commercially available product can also be used as the alkyl alcohol polyalkylene oxide adduct. Examples of the commercially available product of the alkyl alcohol polyalkylene oxide adduct are as follows. Polyoxyethylene methyl ether (a methyl alcohol ethylene oxide adduct) (BLAUNON MP-400, MP-550, and MP-1000) manufactured by AOKI OIL INDUSTRIAL, polyoxyethylene decyl ether (a decyl alcohol ethylene oxide adduct) (FINESURF D-1303, D-1305, D-1307, and D-1310) manufactured by AOKI OIL INDUSTRIAL, polyoxyethylene lauryl ether (a lauryl alcohol ethylene oxide adduct) (BLAUNON EL-1505) manufactured by AOKI OIL INDUSTRIAL, polyoxyethylene cetyl ether (a cetyl alcohol ethylene oxide adduct) (BLAUNON CH-305 and CH-310) manufactured by AOKI OIL INDUSTRIAL, polyoxyethylene stearyl ether (a stearyl alcohol ethylene oxide adduct) (BLAUNON SR-705, SR-707, SR-715, SR-720, SR-730, and SR-750) manufactured by AOKI OIL INDUSTRIAL, randomly polymerized polyoxyethylene polyoxypropylene

stearyl ether (BLAUNON SA-50/50 1000R and SA-30/70 2000R) manufactured by AOKI OIL INDUSTRIAL, polyoxyethylene methyl ether (Pluriol® A760E) manufactured by BASF, and polyoxyethylene alkyl ether (EMULGEN series) manufactured by KAO. A commercially available product can also be used as polyalkylene oxide. An example is an ethylene oxide/propylene oxide copolymer (Pluronic PE6400) manufactured by BASF.

The fluorine-based surfactant shows an excellent mold release force reducing effect and hence is effective as the internal mold release agent. The blending ratio of the component (c) except the fluorine-based surfactant in the curable composition is preferably 0 mass% or more and 50 mass% or less with respect to the total of the components (a), (b), and (c), that is, the total mass of all the components except the solvent. The blending ratio is more preferably 0.1 mass% or more and 50 mass% or less, and further preferably 0.1 mass% or more and 20 mass% or less. When the blending ratio of the component (c) except the fluorine-based surfactant is 50 mass% or less, a cured film having a mechanical strength to some extent can be obtained.

<Component (d): Solvent>

The curable composition according to this embodiment can contain a solvent as the component (d). The component (d) is not particularly limited as long as it is a solvent that dissolves the components (a), (b), and (c). A favorable solvent is a solvent having a boiling point of 80°C or more and 200°C or less at normal pressure. The component (d) is more favorably a solvent having at least one of an ester structure, a ketone structure, a hydroxyl group, and an ether structure. More specifically, the component (d) is a solvent or a solvent mixture selected from propylene glycol monomethyl ether acetate, propylene glycol monomethyl ether, cyclohexane, 2-heptanone, γ-butyrolactone, and ethyl lactate.

The curable composition (A1) according to this embodiment preferably contains the component (d). This is so because a spin coating method is favorable as a method of coating a substrate with the curable composition (A1) as will be described later.

<Temperature When Blending Curable Composition>

When preparing the curable compositions (A1) and (A2) of this embodiment, at least the components (a) and (b) are mixed and dissolved under a predetermined temperature condition. More specifically, mixing and dissolution are performed at 0°C or more and 100°C or less. This is the same when the components (c) and (d) are contained.

<Viscosity of Curable Composition>

The curable compositions (A1) and (A2) according to this embodiment are preferably liquids. This is so because in a mold contact step (to be described later), spread and fill of the curable composition (A1) and/or the curable composition (A2) are rapidly completed, that is, the filling time is short.

The viscosity at 25 °C of the mixture of the components except the solvent (component (d)) of the curable composition (A1) according to this embodiment is preferably 1 mPa•s or more and 1,000 mPa•s or less, more preferably 1 mPa•s or more and 500 mPa•s or less, and further preferably 1 mPa•s or more and 100 mPa•s or less.

The viscosity at 25°C of the mixture of the components except the solvent (component (d)) of the curable composition (A2) according to this embodiment is preferably 1 mPa•s or more and 100 mPa•s or less, more preferably 1 mPa•s or more and 50 mPa•s or less, and further preferably 1 mPa•s or more and 12 mPa•s or less.

When the viscosity of the curable composition (A1) is 1,000 mPa•s or less or the viscosity of the curable composition (A2) is 100 mPa•s or less, spread and fill are rapidly completed when bringing the curable compositions (A1) and (A2) into contact with a mold. That is, the photonanoimprint method can be performed with high throughput by using the curable composition according to this embodiment. In addition, pattern defects hardly occur due to filling failure. Also, when the viscosity is 1 mPa•s or more, uneven coating hardly occurs when coating a substrate with the curable compositions (A1) and (A2). Furthermore, when bringing the curable compositions (A1) and (A2) into contact with a mold, the curable compositions (A1) and (A2) hardly flow out from the end portions of the mold.

<Surface Tension of Curable Composition>

As the surface tension of the curable compositions (A1) and (A2) according to this embodiment, the surface tension of the composition containing the components except the solvent (component (d)) at 23°C is preferably 5 mN/m or more and 70 mN/m or less, more preferably 7 mN/m or more and 50 mN/m or less, and further preferably 10 mN/m or more and 40 mN/m or less. When the surface tension is high, for example, 5 mN/m or more, the capillarity strongly acts. Therefore, filling (spread and fill) is completed within a short time when bringing the curable composition (A1) and/or the curable composition (A2) into contact with a mold. When the surface tension is 70 mN/m or less, a cured film obtained by curing the curable composition has surface smoothness.

In this embodiment, the surface tension of the curable composition (A1) except the solvent (component (d)) is preferably higher than that of the curable composition (A2) except the solvent (component (d)). This is so because before a mold contact step, prespread of the curable composition (A2) is accelerated (droplets are spread within a broad range) by the Marangoni effect (to be described below), and this shortens the time required for spread during the mold contact step (to be described later) and as a consequence shortens the filling time. The Marangoni effect is a phenomenon of free surface movement caused by a local difference between the surface tensions of a liquid. By using the surface tension, that is, the surface energy difference as a driving force, diffusion occurs such that a liquid having a low surface tension covers a wide surface. That is, when the entire surface of a substrate is coated with the curable composition (A1) having a high surface tension and the curable composition (A2) having a low surface tension is dropped after that, prespread of the curable composition (A2) is accelerated.

<Contact Angle of Curable Composition>

As the contact angle of the curable compositions (A1) and (A2) according to this embodiment, the contact angle of the composition containing the components except the solvent (component (d)) is preferably 0° or more and 90° or less, and particularly preferably 0° or more and 10° or less, with respect to both the substrate surface and the mold surface. If the contact angle is larger than 90°, the capillarity may act in the negative direction (a direction in which the contact interface between the mold and the curable composition is contracted) inside the mold pattern or in the substrate-mold gap, and this may make filling impossible. As the contact angle decreases, the capillarity acts more strongly, so the filling rate increases.

<Impurities Mixed in Curable Composition>

The curable compositions (A1) and (A2) according to this embodiment preferably contain impurities as less as possible. The impurities described herein mean components except the above-described components (a), (b), (c), and (d). Accordingly, the curable composition according to this embodiment is favorably obtained through a refining step. This refining step is favorably, for example, filtration using a filter.

More specifically, when performing filtration using a filter, it is favorable to perform filtration by using, for example, a filter having a pore size of 0.001 μm or more and 5.0 μm or less, after the above-described components (a), (b), and (c) are mixed. It is more favorable to perform filtration using a filter in multiple stages or by repeating the filtration a number of times. Also, a filtrated liquid can be filtrated again. Filtration can also be performed by using filters having different pore sizes. As the filter to be used in filtration, it is possible to use filters made of, for example, a polyethylene resin, a polypropylene resin, a fluorine resin, and a nylon resin, but the filter is not particularly limited. Impurities such as particles mixed in the curable composition can be removed through the refining step as described above. This makes it possible to prevent impurities such as particles from unexpectedly forming concave and convex portions on a cured film obtained by curing the curable composition, and generating pattern defects.

Note that when using the curable composition according to this embodiment in order to manufacture a semiconductor integrated circuit, it is favorable to avoid mixing of an impurity (metal impurity) containing metal atoms in the curable composition as much as possible, so as not to obstruct the operation of the product. In this case, the concentration of the metal impurity contained in the curable composition is preferably 10 ppm or less, and more preferably 100 ppb or less.

[Substrate (Base Member)]

In this specification, a member on which an underlayer is arranged will be explained as a substrate or a base member. A structure including a member on which an underlayer is arranged and the underlayer arranged on that object will also be explained as a substrate in some cases. In a case like this, the member on which the underlayer is arranged is preferably understood as a base member in order to avoid confusion.

A substrate as a base member as an object on which an underlayer is arranged is a substrate to be processed, and a silicon wafer is normally used. This substrate as a base member can have a layer to be processed on the surface. Another layer may further be formed under the layer to be processed in the substrate. Also, when using a quartz substrate as this substrate, a replica (mold replica) of a quartz imprint mold can be manufactured. However, this substrate is not limited to a silicon wafer or a quartz substrate. This substrate can also be freely selected from materials known as semiconductor device substrates, for example, aluminum, a titanium-tungsten alloy, an aluminum-silicon alloy, an aluminum-copper-silicon alloy, silicon oxide, and silicon nitride. Note that the surface of the substrate or the layer to be processed to be used can be treated by a surface treatment such as silane coupling treatment, silazane treatment, or deposition of a thin organic film, thereby improving the adhesion to the curable compositions (A1) and (A2). As a practical example of the thin organic film to be deposited as the surface treatment, an adhesive layer described in PTL 6 can be used.

[Underlayer]

The underlayer can be a layer that can easily be processed and has a resistance to an etching process of processing a substrate (base member) as a base of the underlayer or processing another layer. The underlayer can also be formed on the outermost layer of a substrate on which the nanoimprint process is performed. For example, carbon materials such as SOC (Spin On Carbon), diamond-like carbon, and graphite can be used as the material of the underlayer. SOC containing carbon as a main component can be used as a high-etching-resistance material. In pattern formation of nanoimprint, SOC can similarly be used as a high-etching-resistance material. In this embodiment, the nanoimprint process is preferably performed on the SOC layer.

SOC preferably usable as the underlayer material can contain a principal agent (component (P)) and an organic solvent (component (Q)). The underlayer material can also contain an acid generator (component (R)) and/or a crosslinking agent (component (S)), and can further contain other arbitrary components within a range in which the effect of this embodiment is not ruined. Each component will be explained below.

<Component (P): Principal Agent>

The component (P) is a principal agent. The component (P) is a compound having an aromatic ring such as a benzene ring, a naphthalene ring, or an anthracene ring, and having a formula weight of preferably 300 to 5,000, and particularly preferably 500 to 2,500. A molecular weight of 300 or more is advantageous in obtaining good deposition properties, and can suppress contamination of the manufacturing apparatus caused by an increase of sublimates at the time of curing. A molecular weight of 5,000 or less is advantageous in obtaining good embedding/planarization characteristics.

The component (P) can contain a branched or cyclic, saturated or unsaturated hydrocarbon group or heteroaromatic group, and can contain an ether group, a hydroxyl group, an ester group, a carbonyl group, an amino group, a halogen group, a sulfide group, a carboxyl group, a sulfo group, an amide group, an imide group, a cyano group, an aldehyde group, an imino group, a urea group, a carbamate group, a carbonate group, a nitro group, or a sulfonyl group.

Practical examples of the component (P) are novolak-based compounds such as phenol novolak, cresol novolak, and naphthol novolak, and substituted polystyrene compounds such as polyhydroxy styrene and polyhydroxy vinyl naphthalene. As the component (P), it is possible to use one type of a compound alone and two or more types of compounds by mixing them.

<Component (Q): Solvent>

The component (Q) is a solvent. The component (Q) is not particularly limited as long as it can dissolve or disperse the component (P) and an arbitrary component to be contained as needed. Examples of the component (Q) are an alcohol-based solvent, a ketone-based solvent, an ether-based solvent, an ester-based solvent, and a nitrogen-containing solvent. As the component (Q), it is possible to use one type of a solvent alone and two or more types of solvents by combining them.

Examples of the alcohol-based solvent are as follows. Monoalcohol-based solvents such as methanol, ethanol, n-propanol, iso-propanol, n-butanol, iso-butanol, sec-butanol, tert-butanol, n-pentanol, iso-pentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethylheptanol-4, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; and polyalcohol-based solvents such as ethylene glycol, 1,2-prpylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin.

Examples of the ketone-based solvent are as follows. Acetone, methylethylketone, methyl-n-propylketone, methyl-n-butyketone, diethylketone, methyl-iso-butylketone, methyl-n-pentylketone, ethyl-n-butylketone, methyl-n-hexylketone, di-iso-butylketone, trimethylnonanon, cyclohexanone, methylcyclohexanone, 2,4-pentanedione, acetonylacetone, diacetone alcohol, acetophenone, and fenthion.

Examples of the ether-based solvent are as follows. Ethyl ether, iso-propyl ether, n-butyl ether, n-hexyl ether, 2-ethylhexyl ether, ethylene oxide, 1,2-propylene oxide, dioxolane, 4-methyldioxolane, dioxane, dimethyldioxane, 2-methoxyethanol, 2-ethoxyethanol, ethylene glycol diethyl ether, 2-n-butoxyethanol, 2-n-hexoxyethanol, 2-phenoxyethanol, 2-(2-ethylbutoxy)ethanol, ethylene glycol dibutyl ether, diethylene glycol monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, ethoxy triglycol, tetraethylene glycol di-n-butyl ether, 1-n-butoxy-2-propanol, 1-phenoxy-2-propanol, propylene glycol monomethyl ether, propylene glycol monoethyl ether, propylene glycol monopropyl

ether, dipropylene glycol monomethyl ether, dipropylene glycol monoethyl ether, dipropylene glycol monopropyl ether, tripropylene glycol monomethyl ether, tetrahydrofuran, and 2-methyltetrahydrofuran.

Examples of the ester-based solvent are as follows. Diethyl carbonate, methyl acetate, ethyl acetate, amyl acetate, γ-butyrolactone, γ-valerolactone, n-propyl acetate, iso-propyl acetate, n-butyl acetate, iso-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, iso-amyl propionate, diethyl oxalate, di-n-butyl oxalate, methyl lactate, ethyl lactate, n-butyl lactate, n-amyl lactate, diethyl malonate, dimethyl phthalate, and diethyl phthalate.

Examples of the nitrogen-containing solvent are as follows. N-methylformamide, N,N-dimethylformamide, N,N-diethylformamide, acetoamide, N-methylacetoamide, N,N-dimethylacetoamide, N-methylpropionamide, and N-methylpyrrolidone.

Of the above-described solvents, the ether-based solvent and the ester-based solvent are favorable. From the viewpoint of good film formation properties, an ether-based solvent and an ester-based solvent each having a glycol structure are more favorable, propylene glycol monomethyl ether, propylene glycol monoethyl ether, propylene glycol monopropyl ether, propylene glycol monomethyl ether acetate, propylene glycol monoethyl ether acetate, and propylene glycol monopropyl ether acetate are further favorable, and propylene glycol monomethyl ether acetate is particularly favorable.

<Component (R): Acid Generator>

The underlayer material according to this embodiment can contain an acid generator as the component (R). The component (R) is a component that generates an acid by the action of heat or light, and promotes a crosslinking reaction of the crosslinking agent (component (S)) (to be described later) of the component (P). When this curable composition underlayer formation component contains the component (R), the crosslinking reaction of the component (P) is promoted, so the hardness of a film to be formed can further be increased. As the component (R), it is possible to use one type of a component alone and two or more types of components by combining them. Examples of the component (R) are an onium salt compound and an N-sulfonyloxyimide compound.

Examples of the onium salt compound are tetrahydrothiophenium salt, iodonium salt, and ammonium salt.

Examples of the sulfonium salt are triphenylsulfonium trifluoromethane sulfonate, triphenylsulfonium nonafluoro-n-butane sulfonate, triphenylsulfonium 2-bicyclo[2,2,1]hept-2-yl-1,1,2,2-tetrafluoroethane sulfonate, and 4-cyclohexylphenyl diphenylfulfonium trifluoromethane sulfonate.

Examples of the tetrahydrothiophenium salt are 1-(4-n-butoxynaphthalene-1-yl)tetrahydrothiophenium trifluoromethane sulfonate, 1-(4-n-butoxynaphthalene-1 -yl)tetrahydrothiophenium nonafluoro-n-butane sulfonate, and 1-(4-n-butoxynaphthalene-1-yl)tetrahydrothiophenium 2-bicylo[2,2,1]hept-2-yl-1,1,2,2-tetrafluoroethane sulfonate.

Examples of the iodonium salt are diphenyliodonium trifluoromethane sulfonate, diphenyliodonium nonafluoro-n-butane sulfonate, bis(4-t-butylphenyl)iodonium nonafluoro-n-butane sulfonate, and bis(4-t-butylphenyl)iodonium 2-bicyclo[2,2,1]hept-2-yl-1,1,2,2-tetrafluoroethane sulfonate.

Examples of the ammonium salt are triethylammonium trifluoromethane sulfonate and triethylammonium nonafluoro-n-butane sulfonate.

Examples of the N-sulfonyloxyimide compound are N-(trifluoromethanesulfonyloxy)bicyclo[2,2,1]hept-5-ene-2,3-dicarboxyimide, N-(nonafluoro-n-butanesulfonyloxy)bicylo[2,2,1]hept-5-ene-2,3-dicarboxyimide, and N-(2-bicyclo[2,2,1]hept-2-yl-1,1,2,2-tetrafluoroethanesulfonyloxy)bicyclo[2,2,1]hept-5-ene-2,3-dicarboxyimide.

Of these examples of the component (R), the onium salt compound is favorable, the iodonium salt and the ammonium salt are more favorable, and bis(4-t-butylphenyl)iodonium nonafluoro-n-butane sulfonate and triethylammonium nonafluoro-n-butane sulfonate are further favorable.

When this underlayer material contains the component (R), the lower limit of the content of the component (R) is preferably 0.1 part by mass, more preferably 1 part by mass, and further preferably 3 parts by mass, with respect to 100 parts by mass of the component (P). The upper limit of the content is preferably 15 parts by mass, more preferably 12 parts by mass, and further preferably 10 parts by mass. When the content of the component (R) falls within the abovementioned range, the crosslinking reaction of the component (P) can be promoted more effectively.

<Component (S): Crosslinking Agent>

The underlayer material according to this embodiment can also contain a crosslinking agent as the component (S). The component (S) is a component that forms a crosslinking bond between the compounds contained in the component (P) of the underlayer material, or forms a crosslinking structure by itself, by the action of heat or an acid. When the underlayer material contains the component (S), the hardness of an underlayer to be formed can be increased. As the component (S), it is possible to use one type of a component alone or two or more types of components by combining them.

Examples of the component (S) are a polyfunctional (meth)acrylate compound, an epoxy compound, a hydroxymethyl group-substituted phenol compound, an alkoxyalkyl group-containing phenol compound, and a compound having an alkoxyalkylated amino group.

Examples of the polyfunctional (meth)acrylate compound are trimethylolpropane tri(meth)acrylate, ditrimethylolpropane tetra(meth)acrylate, pentaerythritol tri(meth)acrylate, pentaerythritol tetra(meth)acrylate, dipentaerythritol penta(meth)acrylate, dipentaerythritol hexa(meth)acrylate, glycerin tri(meth)acrylate, tris(2-hydroxyethyl)isocyanurate tri(meth)acrylate, ethylene glycol di(meth)acrylate, 1,3-butanediol di(meth)acrylate, 1,4-butanediol di(meth)acrylate, 1,6-hexanediol di(meth)acrylate, neopentyl glycol di(meth)acrylate, diethylene glycol di(meth)acrylate, triethylene glycol di(meth)acrylate, dipropylene glycol di(meth)acrylate, and bis(2-hydroxyethyl)isocyanulate di(meth)acrylate.

Examples of the epoxy compound are a novolak-type epoxy resin, a bisphenol-type epoxy resin, an alicyclic epoxy resin, and an aliphatic epoxy resin.

Examples of the hydroxymethyl group-substituted phenol compound are 2-hydroxymethyl-4,6-dimethylphenol, 1,3,5-trihydroxymethylbenzene, and 3,5-dihydroxymethyl-4-methoxytoluene[2,6-bis(hydroxymethyl)-p-cresol].

Examples of the alkoxyalkyl group-containing phenol compound are a methoxymethyl group-containing phenol compound and an ethoxymethyl group-containing phenol compound.

An example of the compound having an alkoxyalkylated amino group is a nitrogen-containing compound which has a plurality of active methylol groups in one molecule and in which at least one hydrogen atom of a hydroxyl group of the methylol group is substituted by an alkyl group such as a methyl group or a butyl group. Examples are (poly)methyloled melamine such as hexamethoxymethylated melamine, hexabutoxymethylated melamine, their alkoxy and/or hydroxy substitutes, and their partial self-condensates; (poly)methyloled glycoluril such as tetramethoxymethylated glycoluril, tetrabutoxymethylated glycoluril, their alkoxy and/or hydroxy substitutes, and their partial self-condensates; (poly)methyloled benzoguanamine such as tetramethoxymethylated benzoguanamine tetrabutoxymethylated benzoguanamine, their alkoxy and/or hydroxy substitutes, and their partial self-condensates; and (poly)methyloled urea such as dimethoxymethylated dimethoxyethylene urea, its alkoxy and/or hydroxy substitute, and their partial self-condensates. Note that the compound having an alkoxyalkylated amino group can be a mixture of a plurality of substitution compounds, and can also be a compound containing an oligomer component obtained by partial selfcondensation.

When the underlayer material contains the component (S), the lower limit of the content of the component (S) is preferably 0.1 part by mass, more preferably 0.5 parts by mass, further preferably 1 part by mass, and particularly preferably 3 parts by mass, with respect to 100 parts by mass of the component (P). The upper limit of the content is preferably 50 parts by mass, more preferably 40 parts by mass, further preferably 30 parts by mass, and particularly preferably 20 parts by mass. When the content of the component (S) falls within the abovementioned range, the crosslinking reaction of the component (P) can be caused more effectively.

One example of other arbitrary components is a surfactant.

When the underlayer material contains a surfactant, the coating properties can be improved. Consequently, the coating surface uniformity of an underlayer film to be formed improves, and the occurrence of uneven coating can be suppressed. It is possible to use one type of a surfactant alone or two or more types of surfactants by combining them.

When the underlayer material contains a surfactant, the lower limit of the content of the surfactant is preferably 0.01 part by mass, more preferably 0.05 parts by mass, and further preferably 0.1 part by mass, with respect to 100 parts by mass of the principal agent (P). The upper limit of the content is preferably 10 parts by mass, more preferably 5 parts by mass, and further preferably 1 part by mass. When the content of the surfactant falls within the abovementioned range, the coating properties of the underlayer material can further be improved.

The underlayer material can also be a commercially available underlayer material. Examples are Spin-On-Carbon film formation compositions such as Spin-On-Carbon film formation compositions ODL-50, ODL-69, ODL-102, ODL-180, and ODL-301 manufactured by Shin-Etsu Chemical, and NFC-1400 and HM8005 manufactured by JSR, but the underlayer material is not limited to these examples. Note that the underlayer can be formed by one type of a composition or a plurality of types of compositions.

The substrate according to this embodiment can be coated with a mask material as the underlayer. In the present semiconductor miniaturization process, thinning of a curable composition advances together with miniaturization of a processing pattern (feature). Also, if the aspect ratio of the processing pattern increases, a phenomenon called a microloading effect in which the etching rate decreases takes place. Consequently, the etching time prolongs, so the

curable composition mask cannot resist etching any longer in some cases. To accurately form a micropattern with high aspect ratio, a method such as a multilayered curable composition process or an inversion process can be used. In these methods, after a pattern of a curable composition is transferred once to a layer having a high etching resistance (a high-etching-resistance layer) different from the curable composition, a target underlayer can be processed by using the high-etching-resistance layer as an etching mask.

When the ratio of the number of carbon atoms to the total number of atoms except hydrogen in the baked underlayer is 80% or more, the substrate and the curable compositions (A1) and (A2) can strongly adhere to each other after the curable compositions are cured by light irradiation. The ratio of the number of carbon atoms in the underlayer is preferably 80% or more, and more preferably 80% to 95%.

A precursor composition of the underlayer can be a carbon-based material, for example, a mixture of a naphthalene-based compound and a solvent, and can be applied on the substrate by the spin coating method. Normally, the precursor composition of the underlayer can be so applied as to have a thickness of 0.1 nm to 1,000 nm after baking. It is favorable to apply the composition by an amount sufficient to give the substrate surface a uniform flatness. When the substrate is baked after coating, the solvent component volatilizes and carbonization advances, so a carbon film in which the ratio of the number of carbon atoms is 80% or more can be formed. The baking conditions are appropriately adjusted in accordance with the type of a composition to be used. Generally, however, baking is preferably performed at about 200°C to about 350°C for about 30 to 90 sec, and particularly preferably performed at about 220°C to about 300°C for about 45 to 60 sec.

Requirements for the diffusion coefficient and solubility coefficient of an ambient gas with respect to the underlayer will be described later.

[Pattern Forming Method]

A pattern forming method according to this embodiment will be explained below with reference to a schematic sectional view of Fig. 1. A cured film to be formed by this embodiment is preferably a film having a pattern with a size of 1 nm or more and 10 mm or less, and more preferably a film having a pattern with a size of 10 nm or more and 100 μm or less. Note that a pattern forming technique for making a film having a pattern (uneven structure) with a nanosize (1 nm or more and 100 nm or less) by using light is generally called a photonanoimprint method. The film forming method according to this embodiment can use the photonanoimprint method, but a curable composition can also be cured by using another energy (for example, heat or an electromagnetic wave). The film forming method of this embodiment can be performed as a method (pattern forming method) of forming a film having a pattern, and can also be performed as a method of forming a film (for example, a planarized film) having no pattern. First, an example in which the film forming method of this embodiment is applied to the method of forming a film having a pattern will be explained. The film forming method can include a formation step of forming an underlayer, an arranging step of arranging a curable composition on the underlayer, a contact step of bringing the curable composition and a mold into contact with each other, a curing step of curing the curable composition, and a separation step of separating the curable composition and the mold. The arranging step is performed after the formation step, the contact step is performed after the arranging step, the curing step is performed after the contact step, and the separation step is performed after the curing step.

<Formation Step S1>

In the formation step, as schematically shown in S1 of Fig. 1, an underlayer 102 is formed on the surface of a substrate (base member) 101 (when the substrate 101 has a layer to be processed, on the surface of the layer to be processed). In this case, a structure having the substrate (base member) 101 and the underlayer 102 arranged on the substrate 101 can also be called a substrate. The underlayer 102 can be formed by, for example, stacking or applying the material of the underlayer 102 on the substrate 101, and performing a baking step on the substrate 101 coated with the material. Examples of the method of forming the underlayer 102 are an inkjet method, a dip coating method, an air knife coating method, a curtain coating method, a wire bar coating method, a gravure coating method, an extrusion coating method, a spin coating method, and a slit scanning method. The spin coating method is particularly favorable among these methods. When forming the underlayer 102 by using the spin coating method, the solvent component can be volatilized by performing a baking step as needed. For example, the baking step can be performed at about 200°C to about 350°C for about 30 sec to about 90 sec. The baking conditions are appropriately adjusted in accordance with the type of a composition to be used.

The average film thickness of the underlayer 102 can be decided in accordance with the use. For example, the average film thickness is 0.1 nm or more and 10,000 nm or less, preferably 1 nm or more and 250 nm or less, and particularly preferably 5 nm or more and 50 nm or less.

As the underlayer 102, it is also possible to use a multilayered film obtained by stacking, on SOC, a Spin-On-Glass (SOG) film or a silicon oxide film each having a film thickness of 0.1 nm or more and 250 nm or less.

<Arranging Steps S2-1 and S2-2>

In the arranging step, as schematically shown in S2-1 and S2-2 of Fig. 1, a curable composition can be arranged on the underlayer 102 on the substrate (base member) 101. The arranging step can include, for example, a first arranging step of arranging a curable composition (A1) 103 on the underlayer 102, and a second arranging step of discretely dropping droplets of a curable composition (A2) 104 on the curable composition (A1) 103. The curable composition (A1) and the step of arranging that can also be omitted.

Before the arranging step, the adhesion of the surface of the underlayer 102 to the curable composition (A1) and/or the curable composition (A2) can also be improved by surface treatment such as silane coupling treatment, silazane treatment, or deposition of a thin organic film (first arranging step S2-1).

In the first arranging step, as schematically shown in S2-1 of Fig. 1, the curable composition (A1) 103 can be arranged on the underlayer 102. For example, the curable composition (A1) 103 is stacked or applied on the underlayer 102, thereby forming a coating film. In this embodiment, as the method of arranging the curable composition (A1) 103, it is possible to use, for example, an inkjet method, a dip coating method, an air knife coating method, a curtain coating method, a wire bar coating method, a gravure coating method, an extrusion coating method, a spin coating method, or a slit scanning method. The spin coating method is particularly favorable among these methods. When arranging the curable composition (A1) 103 by using the spin coating method, the solvent component (d) can be volatilized by performing a baking step as needed.

The average film thickness of the curable composition (A1) 103 can be decided in accordance with the use. For example, the average film thickness is 0.1 nm or more and 10,000 nm or less, preferably 1 nm or more and 20 nm or less, and particularly preferably 1 nm or more and 10 nm or less. The curable composition (A1) and the step of arranging that can also be omitted. Fig. 2 shows a schematic sectional view when the curable composition (A1) and the step of arranging that are omitted.

(Second Arranging Step S2-2)

In the second arranging step, as schematically shown in S2-2 of Fig. 1, droplets of the curable composition (A2) 104 can discretely be dropped on the curable composition (A1) 103. An inkjet method is favorable as the arranging method. The droplets of the curable composition (A2) 104 are preferably dropped such that they are densely arranged in a region facing a region of the substrate 101 where concave portions forming the pattern of a mold 106 densely exist, and sparsely arranged in a region facing a region of the substrate 101 where the concave portions sparsely exist. Consequently, a residual film 109 (to be described later) can be controlled to have a uniform thickness regardless of whether the pattern of the mold 106 is sparse or dense.

When the curable composition (A1) 103 is arranged, the droplets of the curable composition (A2) 104 arranged in the second arranging step rapidly spread (prespread) as indicated by arrows 105 by the Marangoni effect using the difference between surface energies (surface tensions) as a driving force as described previously. When the curable composition (A1) has practically no photoreactivity, a photopolymerization initiator as the component (b) of the curable composition (A2) moves to the curable composition (A1) as a result of mixing of the curable compositions (A1) and (A2), so the curable composition (A1) can acquire photosensitivity.

<Contact Step S3>

In the contact step as schematically shown in S3 of Fig. 1, the curable composition and the mold 106 are brought into contact with each other. The contact step includes a step of a changing a state in which the curable composition and the mold 106 are not in contact with each other to a state in which they are in contact with each other, and a step of maintaining the state in which they are in contact with each other. In one example, the mold 106 having a pattern to be transferred can be brought into contact with a liquid obtained by mixing the curable compositions (A1) and (A2). As a consequence, the liquid obtained by partially mixing the curable compositions (A1) and (A2) is filled in recesses of fine patterns on the surface of the mold 106, and the filled liquid forms a liquid film filled in the fine patterns of the mold.

When the subsequent curing step includes a photoirradiation step, a mold made of a light-transmitting material can be used as the mold 106 by taking this into consideration. Favorable practical examples of the type of the material forming the mold 106 are glass, quartz, PMMA, a photo-transparent resin such as a polycarbonate resin, a transparent metal deposition film, a soft film such as polydimethylsiloxane, a photo-cured film, and a metal film. Note that when using the photo-transparent resin as the material forming the mold 106, a resin that does not dissolve in components contained in a curable composition can be selected. Quartz is particularly favorable as the material forming the mold 106 because the thermal expansion coefficient is small and pattern distortion is small.

A fine pattern formed on the surface of the mold 106 can have a height of, for example, 4 nm or more and 200

nm or less. As the pattern height decreases, it becomes possible to decrease the force of releasing the mold 106 from the cured film of the curable composition, that is, the mold release force in the separation step, and this makes it possible to decrease the number of mold release defects remaining on the side of the mold 106 because the pattern of the curable composition is torn off in the separation step. Also, in some cases, the pattern of the curable composition elastically deforms due to the impact when the mold is released, and adjacent pattern elements come in contact with each other and adhere to each other or break each other. To avoid these defects, however, it is advantageous to make the height of pattern elements be about twice or less the width of the pattern elements (make the aspect ratio be 2 or less). On the other hand, if the height of pattern elements is too small, the processing accuracy of the substrate 101 may decrease.

A surface treatment can also be performed on the mold 106 before performing the contact step, in order to improve the releasability of the surface of the mold 106 from the curable compositions (A1) and (A2). An example of this surface treatment is to form a mold release agent layer by coating the surface of the mold 106 with a mold release agent. Examples of the mold release agent to be applied on the surface of the mold 106 are a silicon-based mold release agent, a fluorine-based mold release agent, a hydrocarbon-based mold release agent, a polyethylene-based mold release agent, a polypropylene-based mold release agent, a paraffine-based mold release agent, a montane-based mold release agent, and a carnauba-based mold release agent. It is also possible to suitably use a commercially available coating-type mold release agent such as Optool® DSX manufactured by Daikin. Note that it is possible to use one type of a mold release agent alone or two or more types of mold release agents together. Of these mold release agents, fluorine-based and hydrocarbon-based mold release agents are particularly favorable.

In the contact step, the pressure to be applied to the curable compositions (A1) and (A2) when bringing the mold 106 into contact with the curable compositions (A1) and (A2) is not particularly limited. This pressure can be, for example, 0 MPa or more and 100 MPa or less. The pressure is preferably 0 MPa or more and 50 MPa or less, more preferably 0 MPa or more and 30 MPa or less, and further preferably 0 MPa or more and 20 MPa or less.

When prespread of the droplets of the curable composition (A2) 104 has advanced in the second arranging step (S2-2), spread of the curable composition (A2) 104 in the contact step can rapidly be completed. When spread and fill of the curable compositions (A1) and (A2) are quickly completed in the contact step, the time for maintaining the state in which the mold 106 is in contact with the curable compositions (A1) and (A2) (this time will be called a contact step time hereinafter) can be set short. Shortening the contact step time shortens the time required for pattern formation (film formation), and this improves the productivity. The contact step time is preferably 0.1 sec or more and 3 sec or less, and particularly preferably 0.1 sec or more and 1 sec or less. If the contact step time is shorter than 0.1 sec, spread and fill become insufficient, so many defects called unfilling defects tend to occur.

The contact step can be performed under the conditions that a gas (to be referred to as an inner-gap gas hereinafter) exists in the space between the underlayer 102 and the mold 106 and the solubility coefficient of the inner-gap gas with respect to the underlayer 102 is 0.5 $kg/m^3 \cdot atm$ or more and 10 $kg/m^3 \cdot atm$ or less. If the solubility coefficient is larger than 10 $kg/m^3 \cdot atm$, a large amount of the inner-gap gas dissolves, and this may decrease the dry-etching resistance and/or the mechanical strength of the underlayer 102. If the solubility coefficient is smaller than 0.5 $kg/m^3 \cdot atm$, the target effect of the present invention cannot sufficiently be obtained. Also, letting S [$kg/m^3 \cdot atm$] be the solubility coefficient of the inner-gap gas with respect to the underlayer 102, and D [$m^2/s$] be the diffusion coefficient of the inner-gap gas in the underlayer 102, the product (S•D) of S and D is preferably $0.5 \times 10^{-10}$ or more and $10 \times 10^{-10}$ or less. If S•D is larger than $10 \times 10^{-10}$, a large amount of the inner-gap gas dissolves, and this may decrease the dry-etching resistance and/or the mechanical strength of the underlayer 102. If S•D is smaller than $0.5 \times 10^{-10}$, the target effect of the present invention cannot sufficiently be obtained. Furthermore, if the inner-gap gas dissolves by an amount of 1 wt% or more in the curable composition, the dry-etching resistance and/or the mechanical strength of the cured film decreases. Therefore, the solubility of the inner-gap gas into the curable composition at 1 atm is preferably 10 $kg/m^3$ or less.

Practical examples of the inner-gap gas are carbon dioxide, methane, various kinds of chlorofluorocarbon gases, or gas mixtures of two or more of these gases. Carbon dioxide, methane, various kinds of chlorofluorocarbon gases, or gas mixtures of two or more of these gases can also be used by mixing them with a gas not having a high solubility coefficient, such as nitrogen, oxygen, helium, or argon. When using a gas mixture, the diffusion coefficient and solubility coefficient of the gas mixture can be calculated as weighted average values conforming to the molar ratio of each gas. The contact step is performed at a pressure of, for example, 0.0001 atm or more and 10 atm or less.

<Curing Step S4>

In the curing step as schematically shown in S4 of Fig. 1, the curable composition is cured by being irradiated with light as curing energy, thereby forming a cured film. In the curing step, for example, a layer obtained by partially mixing the curable composition (A1) 103 and the curable composition (A2) 104 can be irradiated with light through the mold 106. More specifically, the curable composition (A1) and/or the curable composition (A2) filled in the fine pattern of the mold 106 can be irradiated with light through the mold 106. Consequently, the curable composition (A1) and/or the curable composition (A2) filled in the fine pattern of the mold 106 is cured and forms a cured film 108 having the pattern.

The light 107 to be emitted can be selected in accordance with the sensitivity wavelengths of the curable compositions (A1) and (A2). More specifically, the light 107 can properly be selected from ultraviolet light, X-ray, and an electron beam each having a wavelength of 150 nm or more and 400 nm or less. Among them, the light 107 is particularly preferably ultraviolet light. This is so because many compounds commercially available as curing assistants (photopolymerization initiators) have sensitivity to ultraviolet light. Examples of a light source that emits ultraviolet light are a high-pressure mercury lamp, an ultrahigh-pressure mercury lamp, a low-pressure mercury lamp, a Deep-UV lamp, a carbon arc lamp, a metal halide lamp, a xenon lamp, a KrF excimer laser, an ArF excimer laser, and an $F_2$ excimer laser, and the ultrahigh-pressure mercury lamp is particularly favorable. It is possible to use one light source or a plurality of light sources. Light can be emitted to the entire region of the curable composition (A1) and/or the curable composition (A2) filled in the fine pattern of the mold, and can also be limitedly emitted to only a partial region thereof. It is also possible to intermittently emit light to the entire region of the substrate a plurality of times, or to continuously emit light to the entire region of the substrate. Furthermore, a first region can be irradiated with light in a first irradiation process, and a second region different from the first region can be irradiated with light in a second irradiation process.

In the curing step, light leakage, that is, light diffusion to the outside of the target shot region can occur as described previously, due to restrictions on the costs of the mold and the apparatus. In this embodiment, when the curable composition (A1) has practically no photoreactivity, the curable composition (A1) is not singly cured by light irradiation. Therefore, leakage light generated from the target shot region does not cure the curable composition (A1) on an adjacent shot region. This makes it possible to form a pattern having less unfilling defects within a short filling time in an entire adjacent shot region as well. On the other hand, in the target shot region, the curable compositions (A1) and (A2) are mixed as described earlier, so the photoinitiator (b2) component of the curable composition (A2) moves to the curable composition (A1). As a consequence, the curable composition (A1) acquires photosensitivity, so both the curable compositions (A1) and (A2) are cured by the emitted light, thereby forming the cured film 108 having the pattern.

<Separation Step S5>

In the separation step as schematically shown in S5 of Fig. 1, the cured film 108 and the mold 106 are separated. For example, when the cured film 108 having the pattern and the mold 106 are separated, the cured film 108 having a pattern formed by inverting the fine pattern of the mold 106 is obtained in an independent state. In this state, a cured film remains in recesses of the cured film 108 having the pattern. This film can be called a residual film 109.

When a condensable gas is used as the inner-gap gas in the contact step S3, the condensable gas can vaporize because the pressure in the interface between the cured film 108 and the mold 106 decreases when the cured film 108 and the mold 106 are separated in the separation step. This can reduce the force required to separate the cured film 108 and the mold 106.

A method of separating the mold 106 and the cured film 108 having the pattern can be any method provided that the method does not physically break a part of the cured film 108 having the pattern during the separation, and various conditions and the like are not particularly limited. For example, it is possible to fix the substrate 101 and move the mold 106 away from the substrate 101. It is also possible to fix the mold 106 and move the substrate 101 away from the mold 106. Alternatively, the mold 106 and the cured film 108 can be separated by pulling both of them in exactly opposite directions.

A series of steps (a fabrication process) having above-described steps S2-1 to S5, preferably steps S 1 to S5 in this order make it possible to obtain a cured film having a desired uneven pattern shape (a pattern shape conforming to the uneven shape of the mold 106) in a desired position.

In the film forming method or the pattern forming method of this embodiment, it is possible to stack the curable composition (A1) all at once in a most portion of the substrate surface in step S2-1, and repeatedly perform a repetitive unit (shot) including steps S2-2 to S5 a plurality of times on the same substrate. It is also possible to repeatedly perform steps S2-1 to S5 a plurality of times on the same substrate. It is possible to obtain the cured film 108 having a plurality of desired patterns in desired positions of the substrate by repeating a repetitive unit (shot) including steps S2-1 to S5 or steps S2-2 to S5 a plurality of times.

An example in which the film forming method of this embodiment is applied to a method of forming a film (for example, a planarized film) having no pattern will be explained below. The film forming method can include, for example, a formation step of forming an underlayer, an arranging step of arranging a curable composition on the underlayer, a contact step of bringing the curable composition and a mold into contact with each other, a curing step of curing the curable composition, and a separation step of separating the curable composition and the mold. A mold having a flat surface can be used as the mold, and a cured film having a surface conforming to the flat surface can be formed through the contact step, the curing step, and the separation step. The arranging step is performed after the formation step, the contact step is performed after the arranging step, the curing step is performed after the contact step, and the separation step is performed after the curing step.

<<Method of Manufacturing Circuit Board, Electronic Part, and Optical Apparatus>>

The substrate 101 (when the substrate 101 has a layer to be processed, this layer to be processed) can be processed by using a processing method such as etching by using the cured film 108 having a pattern formed in accordance with the first embodiment as a mask. It is also possible to further deposit a layer to be processed on the cured film 108 having the pattern, and transfer the pattern by using a processing method such as etching. A microstructure such as a circuit structure can be formed on the substrate 101 by using the cured film 108 having the pattern as described above. Consequently, a device such as a semiconductor device can be manufactured. It is further possible to form an apparatus including the device, for example, an electronic apparatus such as a display, a camera, or a medical apparatus. Examples of the device are an LSI, a system LSI, a DRAM, an SDRAM, an RDRAM, a D-RDRAM, and a NAND flash.

It is also possible to obtain an optical part using the cured film 108 having the pattern formed in accordance with the first embodiment as an optical member (or as one member of an optical member) such as a diffraction grating or a polarizing plate. In a case like this, an optical part including at least the substrate 101 and the cured film 108 having a pattern on the substrate 101 can be obtained.

A device such as a semiconductor device can also be manufactured by performing a well-known photolithography step such as a nanoimprint lithography (NIL) technique or an extreme ultraviolet exposure technique (EUV) on a film (for example, a planarized film) having no pattern formed in accordance with the first embodiment.

<<Second Embodiment>>

A film forming method of the second embodiment can be performed as a method of forming a film (for example, a planarized film) having no pattern, and can also be performed as a method (pattern forming method) of forming a film having a pattern. First, an example in which the film forming method of the third embodiment is applied to a method of forming a film having no pattern will be explained. This film forming method can include, for example, a formation step of forming an underlayer, an arranging step of arranging a curable composition on the underlayer, a contact step of bringing the curable composition and a mold into contact with each other, a curing step of curing the curable composition, and a separation step of separating the curable composition and the mold. The arranging step is performed after the formation step, the contact step is performed after the arranging step, the curing step is performed after the contact step, and the separation step is performed after the curing step. In the contact step, as schematically shown in Fig. 3, a mold 18 having a flat surface as a surface of contact with a curable composition is used.

The mold 18 has a surface (contact surface) to be brought into contact with a curable composition, and this surface can be made of an organic material. The mold 18 can include a base member 220, and a protective layer 210 for covering the base member 220. The base member 220 of the mold 18 can be made of, for example, a glass-based material, silicon, spinel, fused quartz, synthetic quartz, silicon, an organic polymer, a siloxane polymer, a fluorocarbon polymer, a metal, cured sapphire, other similar materials, or a combination of two or more of these materials. The glass-based material can include, for example, soda-lime glass, borosilicate glass, alkali•barium•silicate glass, aluminosilicate glass, synthetic quartz, or fused quartz. The protective layer 210 need not be formed if, for example, the base member 220 of the mold 18 is made of an organic material such as an organic polymer, a siloxane polymer, or a fluorocarbon polymer, and has a thickness of 2 $\mu$m or more.

The protective layer 210 can have a multilayered structure. Also, the protective layer 210 forming the surface of the mold 18 can be made of an organic material. The outermost surface of the protective layer 210 is preferably a fluorine resin. The protective layer 210 can be made of, for example, a hydrocarbon polymer or a fluorine-based resin. As the hydrocarbon polymer, it is possible to use, for example, polytrimethylsilyl•propine (PTMSP), an acrylic resin such as polymethyl methacrylate (PMMA), a polycarbonate polymer, polyimide, polyimide, polyethylene, or polypropylene. As the fluorine-based resin, it is possible to use, for example, polytetrafluoroethylene (PTFE), polyvinylidene fluoride (PVDF), perfluoroalkoxy alkane (PFA), a perfluoroethylene propene copolymer (FEP), or an amorphous fluoropolymer. The amorphous fluoropolymer can include a perfluorodioxol tetrafluoroethylene copolymer. The amorphous fluoropolymer can include a chemical structure containing $-(CXY-CF_2-)a-(-Z-)b-$ where X and Y can be F, Cl, or H, and Z can be a four-membered, five-membered, or six-membered fluorocarbon cyclic structure containing at least one C-O-C bond. Alternatively, the amorphous fluoropolymer can include, for example, a copolymer of bistrifluoromethyl-4,5-difluoro-1,3-dioxol (PDD) (shown in, for example, formula 1). The amorphous fluoropolymer can also include a chemical structure containing $-(CF_2-Z-CF_2-)$ where X and Y can be F, Cl, or H, and, as shown in formula 2, Z can be a four-membered, five-membered, or six-membered fluorocarbon cyclic structure containing at least one C-O-C bond. Examples of a commercially available fluorine-based resin are Teflon (DuPont) and Cytop (AGC).

The height difference between concave and convex portions on the surface of the mold 18 is preferably 4 nm or less. A cured film having a surface conforming to the flat surface of the mold 18 can be formed by performing the curing step S4 and the separation step S5, after the contact step of bringing the mold 18 into contact with the curable composition.

The contact step can be performed under the conditions that, for example, a gas (to be referred to as an inner-gap gas hereinafter) exists in the space between a substrate 200 and the mold 18, and the solubility coefficient of the inner-gap gas with respect to the organic material forming the surface of the mold 18 or to the protective layer 210 is 0.5 $kg/m^3$•atm or more and 10 $kg/m^3$•atm or less. If the solubility coefficient is larger than 10 $kg/m^3$•atm, the protective layer 210 may be released from the base member 220 due to expansion of the protective layer 210. Also, letting S [$kg/m^3$•atm] be the solubility coefficient of the inner-gap gas with respect to the organic material forming the surface of the mold 18 or to the protective layer 210, and D [$m^2/s$] be the diffusion coefficient of the inner-gap gas in the organic material forming the surface of the mold 18 or in the protective layer 210, the product (S•D) of S and D is preferably $0.5 \times 10^{-10}$ or more and $10 \times 10^{-10}$ or less. If S•D is larger than $10 \times 10^{-10}$, the protective layer 210 may be released from the base member 220 due to expansion of the protective layer 210. Furthermore, if the inner-gap gas dissolves by an amount of 1 wt% or more in the curable composition, the dry-etching resistance and/or the mechanical strength of the cured film decreases. Therefore, the solubility of the inner-gap gas into the curable composition at 1 atm is preferably 10 $kg/m^3$ or less.

Practical examples of the inner-gap gas are carbon dioxide, methane, various kinds of flon gases, or gas mixtures of two or more of these gases. Carbon dioxide, methane, various kinds of flon gases, or gas mixtures of two or more of these gases can also be used by mixing them with a gas not having a high solubility coefficient, such as nitrogen, oxygen, helium, or argon. When using a gas mixture, the diffusion coefficient and solubility coefficient of the gas mixture can be calculated as weighted average values conforming to the molar ratio of each gas. The contact step can be performed at a pressure of, for example, 0.0001 atm or more and 10 atm or less.

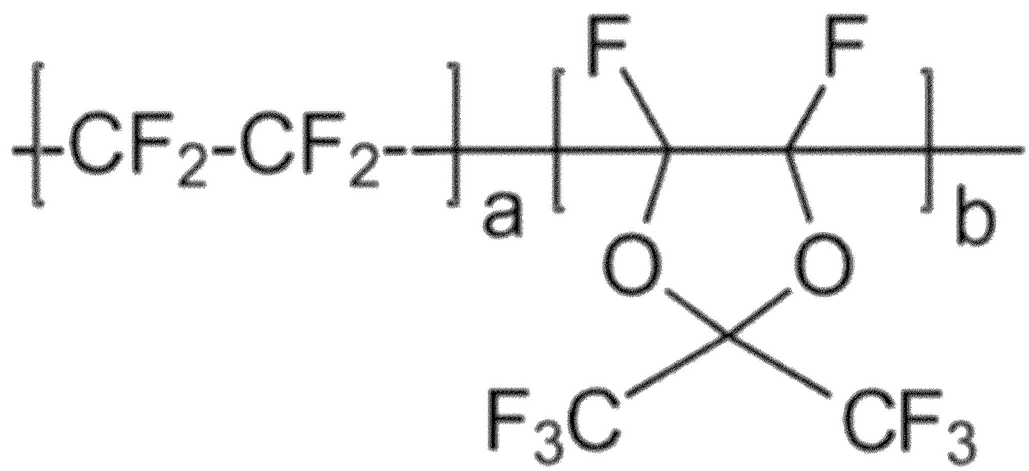

...(1)

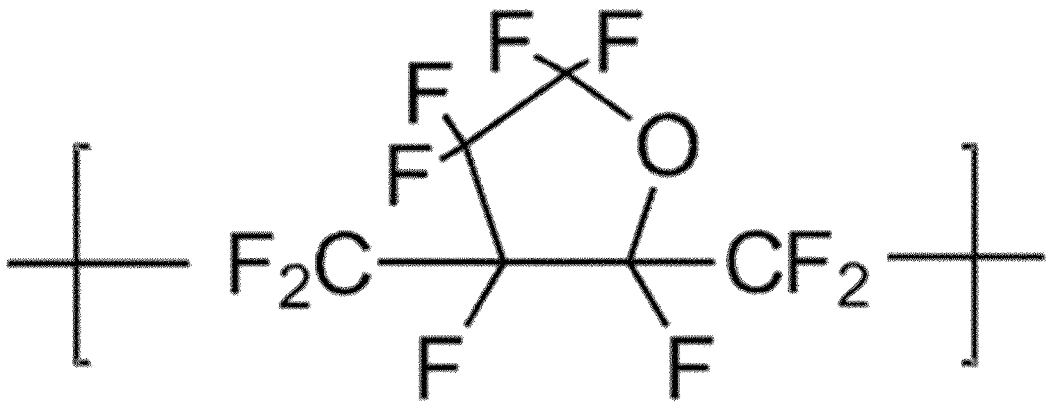

...(2)

A well-known photolithography step such as the nanoimprint lithography (NIL) technique or the extreme ultraviolet exposure technique (EUV) can be performed on the flat cured film obtained by the abovementioned film forming

method. Also, a photolithography step can be performed by stacking a spin-on-glass (SOG) film and/or a silicon oxide film, and coating the film and/or the layer with a curable composition. Consequently, a device such as a semiconductor device can be manufactured. It is also possible to form an apparatus including the device like this, for example, an electronic apparatus such as a display, a camera, or a medical apparatus. Examples of the device are an LSI, a system LSI, a DRAM, an SDRAM, an RDRAM, a D-RDRAM, and a NAND flash.

An example in which the film forming method of the second embodiment is applied to a method (pattern forming method) of forming a film having a pattern will be explained below. This film forming method can include a formation step of forming an underlayer, an arranging step of arranging a curable composition on the underlayer, a contact step of bringing the curable composition and a mold into contact with each other, a curing step of curing the curable composition, and a separation step of separating the curable composition and the mold. The mold has a pattern, and a film on which the pattern is transferred can be formed through the contact step, the curing step, and the separation step. The arranging step is performed after the formation step, the contact step is performed after the arranging step, the curing step is performed after the contact step, and the separation step is performed after the curing step.

[Examples]

More practical examples will be explained below in order to supplement the abovementioned embodiments.

<Filling Time Calculation in Pattern Formation>

A time required when a mold came in contact with droplets of a liquid curable composition (A2) dropped in the form of a square array on an underlayer, adjacent droplets collided with each other and formed air bubbles, and the formed air bubbles dissolved in the curable composition (A2), the mold, and the underlayer and completely disappeared, was theoretically calculated as will be described below. This time is the filling time.

The filling time is the sum of a dynamic spread time and a static spread time. The dynamic spread time is a time required when the mold comes in contact with the curable composition, and adjacent droplets come in contact with each other and form air bubbles by confining a gas (inner-gap gas) in the interfaces between three phases, that is, the mold, the substrate, and the droplets. The static spread time is a time required when the formed air bubbles dissolve in the curable composition (A2), the mold, and the underlayer and completely disappear.

The dynamic spread time was calculated by coupling a lubrication equation for columnar droplets of the curable composition (A2) and a motion equation of the mold. The lubrication equation was adopted because the spacing between droplets to be applied is about 100 μm and the height of the droplet distribution is on the other of about a few nm to a few μm, that is, the aspect is high, so a change in pressure in the direction of height can be ignored. Also, the droplet was handled as an incompressible fluid because the Reynolds number can be regarded as being sufficiently small. The aforementioned coupled equations have an analysis solution, and a dynamic spread time $T_{DS}$ is:

$$T_{DS} = \frac{\pi(R^4 - R_0^4)}{4V} \frac{3\mu\pi}{4\sigma(\cos\theta_u + \cos\theta_d)} \quad \ldots(3)$$

In this equation, V is the volume of one droplet, R is the half of the spacing between droplets, $R_0$ is the radius of the column of the droplet of the curable composition (A2), $\mu$ is the viscosity of the curable composition (A2), $\sigma$ is the surface tension, $\theta_u$ is the contact angle between the curable composition (A2) and the mold, and $\theta_d$ is the contact angle between the curable composition and the underlayer.

Next, a method of calculating a time Tss required for static spread will be explained. As shown in Fig. 4, at the moment the droplets of the curable composition (A2) collide with each other, an air bubble indicated by a blank portion is approximated by a column having a radius $r_g$ and having the same volume, and the calculation region is also approximated by a column having a radius $r_c$ and having the same volume. Under the initial conditions thus made, a time evolution equation of the air bubble volume, a pressure $p_g$, and a height h of the mold can be obtained by coupling a state equation of an ideal gas, an equation of the mass of the gas, a diffusion equation of the gas to the mold, a diffusion equation of the gas to the underlayer, a diffusion equation of the gas to the curable composition (A2), an equation representing conservation of the mass of the curable composition (A2), a lubrication equation of the curable composition

region, and a motion equation of the mold. The equation of the ideal gas is given by:

$$p_g = \mathrm{\rho_g} RT \qquad ...(4)$$

In this equation, $p_g$ is the pressure of the gas, $\rho_g$ is the density of the gas, R is a gas constant, and T is the temperature. The equation of the mass of the gas is given by:

$$\pi r_g^2 \rho_g = M_g \qquad ...(5)$$

In this equation, $M_g$ is the mass of the gas.

The diffusion equation regarding the diffusion of the gas to the mold or the underlayer is given by:

$$\frac{dc_g}{dt} = \mathrm{D_g} \nabla^2 c_g \qquad ...(6)$$

In this equation, $C_g$ is the gas concentration of the mold, and $D_g$ is the diffusion coefficient of the gas to the mold or the underlayer. The boundary conditions were that dissolution conforming to Henry's law occurs on only a surface where the mold or the underlayer and an air bubble are in contact with each other, and that no matter exchange occurs from a surface in contact with the curable composition (A2).

The diffusion equation regarding the diffusion of the gas to the curable composition (A2) is the same as the diffusion equation regarding the diffusion of the gas to the mold or the underlayer. However, the boundary conditions were that dissolution conforming to Henry's law occurs on only a surface where the curable composition (A2) and an air bubble are in contact with each other, and that no matter exchange occurs from a surface in contact with the mold or from the circumferential surface of the column in the calculation region. The equation representing conservation of the mass of the curable composition (A2) is given by:

$$\mathrm{\rho_r} \pi \left(r_c^2 - r_g^2\right) h = \rho_r V_d = M_r \qquad ...(7)$$

In this equation, $\rho_l$ is the density of the curable composition (A2), $V_d$ is the volume of the droplet of the curable

composition (A2), and $M_r$ is the total mass of the curable composition (A2). The lubrication equation of the region of the curable composition (A2) is given by:

$$\frac{h^3}{12\mu}\frac{1}{r}\frac{\partial}{\partial r}r\frac{\partial p_r}{\partial r}=\frac{dh}{dt} \quad \ldots(8)$$

In this equation, $\mu$ is the viscosity of the curable composition (A2) as described above. The motion equation of the mold is given by:

$$\pi r_c^2\rho_m h_m\frac{d^2h}{dt^2}=\pi r_g^2 p_g+\int_{\theta=0}^{2\pi}\int_{r=r_g}^{r_c}p_r(r)rdrd\theta \quad \ldots(9)$$

Letting RLT be the target film thickness, a condition that the thickness h of the curable composition (A2) satisfies the following inequality:

$$\frac{(h-RLT)}{RLT}<10^{-5} \quad \ldots(10)$$

was set as the termination condition of the static spread calculation.

Note that when there was no underlayer and droplets of the curable composition (A2) were directly arranged on a silicon substrate, the calculations were performed by assuming that the solubility and diffusion coefficient of the underlayer were 0.

<Filling Time Calculation in Planarization>

In the case of planarization, the calculation was performed by assuming that the organic material or the protective layer forming the mold surface plays the same role as that of the underlayer in the filling time calculation in pattern formation.

<Calculation of Diffusion Coefficient of Gas in Curable Composition>

In this example, the diffusion coefficient of the gas in the curable composition was calculated by using a molecular dynamics calculation with respect to a molecular aggregate containing 10 gas molecules with respect to 500 molecules forming the curable composition (A2). In this example, the molecular dynamics calculation was performed by using GROMACS-2016. 4 (Copy right (c) 2001 - 2017, The GROMACS development team at Uppsala University, Stockholm University and the Royal Institute of Technology, Sweden.) The method of the molecular dynamics calculation is described in NPL 3.

In the molecular dynamics calculation, an equilibrium state was sampled by arranging target molecules in a unit lattice on which the periodic boundary condition was imposed, calculating a force acting between atoms contained in each molecule with respect to each time, and calculating the loci of all atoms with respect to time evolution.

To perform the molecular dynamics calculation, it is necessary to previously set a parameter called a force field parameter for defining the interaction between atoms, and the setting method will be described later. The molecular dynamics calculation includes three stages, that is, a compression process, a relaxation process, an equilibration process, and production run. The compression process is performed to form an appropriate molecular aggregate, the equilibration process is performed to lead the calculation system to a thermodynamic equilibrium state, and sampling of the equilibrium state is performed in production run. The calculation conditions for use in the compression process are a simulation time of 40 ps, a temperature of 700K, a compression ratio set value of 0.000045, and an atmospheric pressure set value of 10,000 atm, and the process is constant-temperature, constant-pressure simulation using the Berendsen method. The calculation conditions for use in the equilibration process are a simulation time of 5 ns, a temperature of 300K, a compression ratio set value of 0.000045, and an atmospheric pressure set value of 1 atm, and the process is constant-temperature, constant-pressure simulation using the Berendsen method. The calculation conditions for use in production run are a simulation time of 20 ns, a temperature of 300K, a compression ratio set value of 0.000045, and an atmospheric pressure set value of 1 atm, and the process is constant-temperature, constant-pressure simulation using the Berendsen method.

The diffusion coefficient was calculated from the mean square displacement of gas molecules based on the history of molecular motion obtained by the above-described production run.

The force field parameter includes two types of parameters, that is, an electrostatic force field parameter and a non-electrostatic force field parameter. The following was used for the electrostatic force field parameter. An electric charge to be allocated to each atom, which is obtained by performing electric charge fitting by using a point based on the MERZ-Singh-Killmans scheme with respect to an electrostatic potential calculated by the Kohn-Sham method (an exchange correlation functional is B3LYP), a basic function 6-31g*) as one method of a quantum chemical calculation. More specifically, in this example, the quantum chemical calculations were performed by using the following. Gaussian 09 manufactured by Gaussian (Gaussian 09, Revision C.01, M.J.Frisch, G.W.Trucks, H.B.Schlegel, G.E.Scuseria, M.A.Robb, J.R.Cheeseman, G.Scalmani, VBarone, B.Mennucci, G.A.Petersson, H.Nakatsuji, M.Caricato, X.Li, H.P.Hratchian, A.F.Izmaylov, J.Bloino, G.Zheng, J.L.Sonnenberg, M.Hada, M.Ehara, K.Toyota, R.Fukuda, J.Hasegawa, M.Ishida, T.Nakajima, YHonda, O.Kitao, H.Nakai, T.Vreven, J.A.Montgomery,Jr., J.E.Peralta, F.Ogliaro, M.Bearpark, J.J.Heyd, E.Brothers, K.N.Kudin, VN.Staroverov, T.Keith, R.Kobayashi, J.Normand, K.Raghavachari, A.Rendell, J.C.Burant, S.S.Iyengar, J.Tomasi, M.Cossi, N.Rega, J.M.Millam, M.Klene, J.E.Knox, J.B.Cross, VBakken, C.Adamo, J.Jaramillo, R.Gomperts, R.E.Stratmann, O.Yazyev, A.J.Austin, R.Cammi, C.Pomelli, J.W.Ochterski, R.L.Martin, K.Morokuma, VG.Zakrzewski, G.A.Voth, P.Salvador, J.J.Dannenberg, S.Dapprich, A.D.Daniels, O.Farkas, J.B.Foresman, J.VOrtiz, J.Cioslowski, and D.J.Fox, Gaussian, Inc., Wallingford CT, 2010.) The Merz-Singh-Killmans scheme is described in NPLs 4 and 5.

As the non-electrostatic force field, general Amber force field (GAFF) generally used for organic molecules was used.

<Method of Experimentally Measuring Filling Time in Pattern Forming Method>

A curable composition (A2-1) containing 9.0 parts by weight of isobornyl acrylate (manufactured by KYOEISHA CHEMICAL, product name: IB-XA), 38 parts by weight of benzyl acrylate (manufactured by Osaka Organic Chemical, product name: V#160), 47 parts by weight of neopentyl glycol diacrylate (KYOEISHA CHEMICAL, product name: NP-A), and 3 parts by weight of Lucirin TPO (manufactured by BASF) was prepared.

Within a range of 26 × 33 mm on a silicon substrate or on a silicon substrate coated with a 200-nm thick underlayer, 3.25-pL droplets of the curable composition (A2-1) were uniformly dropped in the form of a 140-μm square array, and a quartz blank mold (to be referred to as a mold hereinafter) was brought into contact with the droplets. ODL-301 manufactured by Shin-Etsu Chemical was used as the underlayer material.

The spreading behavior of the droplets of the curable composition (A2-1), that is, the contracting/vanishing behavior of air bubbles confined in the three-phase interface of the mold/substrate/curable composition (A2-1) was observed through the mold by using an optical microscope having a magnifying power of 5X, the time required for vanishing was measured, and the time from the contact between the curable composition and the mold to the vanishing of the air bubbles was measured as the filling time.

In a helium atmosphere (inner-gap gas = helium), the filling time was 2.7 sec when the underlayer film thickness was 0 nm, and 0.7 sec when that was 200 nm. In an air atmosphere (inner-gap gas = air), bubbles did not vanish even after an elapse of 24 sec when the underlayer film thickness was 0 nm, and the filling time was 0.6 sec when that was 200 nm. In a carbon dioxide atmosphere (inner-gap gas = carbon dioxide), the filling time was 2.67 times that in the helium atmosphere when the underlayer film thickness was 0.

<Liquid Properties of Curable Composition Used in Pattern Forming Method>

The viscosity, the surface tension, the contact angle with respect to the substrate, and the contact angle with respect to the mold, of the curable composition (A2-1) were measured in order to theoretically calculate the filling time. Table 1 shows the results.

Table 1

| | |
|---|---|
| Viscosity of curable composition [mPa•s] | 5.6 |
| Surface tension of curable composition [mN/m] | 31 |
| Contact angle of curable composition with respect to substrate [°] | 0 |
| Contact angle of curable composition with respect to mold [°] | 0 |

<Liquid Physical Properties of Curable Composition Used in Planarization Method>

In this example, various calculations were performed on a model curable composition (A2-2) having the viscosity, the surface tension, the contact angle with respect to the substrate, and the contact angle with respect to the organic material or the protective layer forming the surface of the mold as shown in Table 2.

Table 2

| | |
|---|---|
| Viscosity of curable composition [mPa•s] | 15 |
| Surface tension of curable composition [mN/m] | 30 |
| Contact angle of curable composition with respect to substrate [°] | 5 |
| Contact angle of curable composition with respect to protective layer [°] | 60 |

<Theoretical Calculation Example of Filling Time Regarding Pattern Formation>

Table 3 collectively shows the diffusion coefficients and solubility coefficients of gases (helium, nitrogen, oxygen, and carbon dioxide) in the curable composition (A2), the underlayer, and the mold required for the theoretical calculation of the filling time.

[Table 3]

| | Helium | Nitrogen | Oxygen | Carbon dioxide |
|---|---|---|---|---|
| Solubility coefficient with respect to mold [$kg/m^3$•atm] | 0.0027 | 0 | 0 | 0 |
| Diffusion coefficient in mold [$m^2/s$] | $1.2\times10^{-12}$ | 0 | 0 | 0 |
| Solubility coefficient with respect to curable composition [$kg/m^3$•atm] | 0.004 | 0.11 | 0.13 | 1.8 |
| Diffusion coefficient in curable composition [$m^2/s$] | $5\times10^{-9}$ | $2.5\times10^{-10}$ | $2.5\times10^{-10}$ | $5\times10^{-11}$ |
| Solubility coefficient with respect to underlayer [$kg/m^3$•atm] | 0.0018 | 0.18 | 0.21 | 2.8 |
| Diffusion coefficient in underlayer [$m^2/s$] | $1.4\times10^{-9}$ | $2.00\times10^{-10}$ | $1.75\times10^{-10}$ | $1.30\times10^{-10}$ |

The bases of the physical property values described in Table 2 will be explained below.

The solubility coefficients and diffusion coefficients of helium, nitrogen, oxygen, and carbon dioxide with respect to a silicon substrate were 0. This is based on the well-known fact that gases hardly penetrate silicon crystal.

Well-known values were used as the diffusion coefficient of helium in the mold, and the solubility coefficient of helium with respect to the mold.

For carbon dioxide, nitrogen, and oxygen, the solubility coefficient with respect to the mold and the diffusion coefficient in the mold were 0. This is based on the well-known fact that carbon dioxide, nitrogen, and oxygen hardly penetrate the mold when compared to helium.

The solubility coefficients of helium, nitrogen, oxygen, and carbon dioxide with respect to the curable composition

(A2) and, for helium, nitrogen, oxygen, and carbon dioxide in the curable composition, the diffusion coefficient of isobornyl acrylate as one component of the curable composition (A2-1), were obtained by using the molecular dynamics calculation.

As the solubility coefficient of helium with respect to the curable composition (A2), as shown in Comparative Example 1 in Table 4 (to be described later), a value by which the calculated value of the filling time without any underlayer matched the found value of the filling time without any underlayer was adopted.

As the solubility coefficient of each of nitrogen and oxygen with respect to the curable composition (A2), as shown in Comparative Example 2 in Table 4 (to be described later), a value by which the calculated value of the filling time without any underlayer matched the found value of the filling time without any underlayer was adopted.

As the solubility coefficient of carbon dioxide with respect to the curable composition (A2), as shown in Comparative Example 3 in Table 4 (to be described later), a value by which the calculated value of the filling time without any underlayer matched the found value of the filling time without any underlayer was adopted.

As each of the solubility coefficient of helium with respect to the underlayer and the diffusion coefficient of helium in the underlayer, as shown in Comparative Example 4 in Table 5 (to be described later), a value by which the calculated value of the filling time when the underlayer was 200 nm matched the found value of the filling time when the underlayer was 200 nm was adopted.

The diffusion coefficients of nitrogen, oxygen, and carbon dioxide in the underlayer were calculated from the mass ratio to helium, by assuming that the diffusion coefficient of a gas molecule in the underlayer is inversely proportional to the molecular weight of the gas molecule.

As each of the solubility coefficients of nitrogen and oxygen in the underlayer, as shown in Comparative Example 5 in Table 5 (to be described later), a value by which the calculated value of the filling time when the underlayer was 200 nm matched the found value of the filling time when the underlayer was 200 nm was adopted.

As the solubility coefficient of carbon dioxide with respect to the underlayer, a value obtained by assuming that the ratio of the solubility coefficient of carbon dioxide with respect to the underlayer to the solubility coefficient of nitrogen with respect to the underlayer matches the ratio of the solubility coefficient of carbon dioxide with respect to the curable composition (A2) to the solubility coefficient of nitrogen with respect to the curable composition (A2) was used.

As each of the diffusion coefficient and solubility coefficient of the gas mixture, a weighted average value conforming to the molar ratio of each gas was used.

[Comparative Example 1, Comparative Example 2, Comparative Example 3]

In the pattern forming method using no underlayer, the filling times when using helium, nitrogen, and carbon dioxide as an ambient gas (inner-gap gas) were calculated by inputting the various coefficients described in Tables 1 and 3. The volume of the droplet of the curable composition was set at 3.5 pl, the film thickness after filling was set at 28 nm, and the diameter of the droplet at the start timing was set at 100 μm. The mold thickness was 1 mm. Table 4 shows the calculation results and the found values of the filling time.

[Table 4]

| | Comparative Example 1 | Comparative Example 2 | Comparative Example 3 |
|---|---|---|---|
| Ambient gas | Helium | Nitrogen | Carbon dioxide |
| Underlayer thickness | No underlayer | No underlayer | No |
| | | | underlayer |
| Theoretical filling time [s] | 2.7 | 21.7 | 7.3 |
| Found filling time [s] | 2.7 | >24 | 7.2 |

[Comparative Example 4, Comparative Example 5, Example 1]

In pattern formation in which the thickness of the underlayer was 200 nm, the filling times when using helium, nitrogen, and carbon dioxide as an ambient gas (inner-gap gas) were calculated by inputting the various coefficients described in Tables 1 and 2. The volume of the droplet of the curable composition (A2-1) was set at 3.5 pl, the film thickness after filling was set at 28 nm, and the diameter of the droplet at the start timing was set at 100 μm. The mold thickness was 1 mm. Table 5 shows the calculation results and the found values of the filling time.

Table 5

| | Comparative Example 4 | Comparative Example 5 | Example 1 |
|---|---|---|---|
| Ambient gas | Helium | Nitrogen | Carbon dioxide |
| Underlayer thickness [nm] | 200 | 200 | 200 |
| Theoretical filling time [s] | 0.75 | 0.60 | 0.21 |
| Found filling time [s] | 0.75 | 0.60 | No data |

It was confirmed by the theoretical calculations that the filling time is short in the carbon dioxide atmosphere.

[Comparative Example 6, Comparative Example 7, Example 2]

In pattern formation in which the thickness of the underlayer was 50 nm, the filling times when using helium, nitrogen, and carbon dioxide as an ambient gas (inner-gap gas) were calculated by inputting the various coefficients described in Tables 1 and 3. The volume of the droplet of the curable composition (A2-1) was set at 3.5 pl, the film thickness after filling was set at 28 nm, and the diameter of the droplet at the start timing was set at 100 μm. The mold thickness was 1 mm. Table 6 shows the calculation results of the filling time.

Table 6]

| | Comparative Example 6 | Comparative Example 7 | Example 2 |
|---|---|---|---|
| Ambient gas | Helium | Nitrogen | Carbon dioxide |
| Underlayer thickness [nm] | 50 | 50 | 50 |
| Theoretical filling time [s] | 1.5 | 1.9 | 0.40 |
| Found filling time [s] | No data | No data | No data |

It was confirmed by the theoretical calculations that the filling time is short in the carbon dioxide atmosphere.

[Comparative Example 8, Comparative Example 9, Example 3]

In pattern formation in which the thickness of the underlayer was 40 nm, the filling times when using helium, nitrogen, and carbon dioxide as an ambient gas (inner-gap gas) were calculated by inputting the various coefficients described in Tables 1 and 3. The volume of the droplet of the curable composition (A2-1) was set at 3.5 pl, the film thickness after filling was set at 28 nm, and the diameter of the droplet at the start timing was set at 100 μm. The mold thickness was 1 mm. Table 7 shows the calculation results of the filling time.

[Table 7]

| | Comparative Example 8 | Comparative Example 9 | Example 3 |
|---|---|---|---|
| Ambient gas | Helium | Nitrogen | Carbon dioxide |
| Underlayer thickness [nm] | 40 | 40 | 40 |
| Theoretical filling time [s] | 1.6 | 2.27 | 0.46 |
| Found filling time [s] | No data | No data | No data |

It was confirmed by the theoretical calculations that the filling time is short in the carbon dioxide atmosphere.

[Comparative Example 10, Comparative Example 11, Example 4]

In pattern formation in which the thickness of the underlayer was 30 nm, the filling times when using helium, nitrogen, and carbon dioxide as an ambient gas (inner-gap gas) were calculated by inputting the various coefficients described in Tables 1 and 3. The volume of the droplet of the curable composition (A2-1) was set at 3.5 pl, the film thickness after filling was set at 28 nm, and the diameter of the droplet at the start timing was set at 100 μm. The mold thickness was 1 mm. Table 8 shows the calculation results of the filling time.

Table 8]

| | Comparative Example 10 | Comparative Example 11 | Example 4 |
|---|---|---|---|
| Ambient gas | Helium | Nitrogen | Carbon dioxide |
| Underlayer thickness [nm] | 30 | 30 | 30 |
| Theoretical filling time [s] | 1.8 | 2.88 | 0.57 |
| Found filling time [s] | No data | No data | No data |

It was confirmed by the theoretical calculations that the filling time is short in the carbon dioxide atmosphere.

[Comparative Example 12, Comparative Example 13, Example 5]

In pattern formation in which the thickness of the underlayer was 20 nm, the filling times when using helium, nitrogen, and carbon dioxide as an ambient gas (inner-gap gas) were calculated by inputting the various coefficients described in Tables 1 and 3. The volume of the droplet of the curable composition (A2-1) was set at 3.5 pl, the film thickness after filling was set at 28 nm, and the diameter of the droplet at the start timing was set at 100 $\mu$m. The mold thickness was 1 mm. Table 9 shows the calculation results of the filling time.

Table 9]

| | Comparative Example 12 | Comparative Example 13 | Example 5 |
|---|---|---|---|
| Ambient gas | Helium | Nitrogen | Carbon dioxide |
| Underlayer thickness [nm] | 20 | 20 | 20 |
| Theoretical filling time [s] | 2.0 | 3.98 | 0.77 |
| Found filling time [s] | No data | No data | No data |

It was confirmed by the theoretical calculations that the filling time is short in the carbon dioxide atmosphere.

[Comparative Example 14, Comparative Example 15, Example 6]

In pattern formation in which the thickness of the underlayer was 10 nm, the filling times when using helium, nitrogen, and carbon dioxide as an ambient gas (inner-gap gas) were calculated by inputting the various coefficients described in Tables 1 and 3. The volume of the droplet of the curable composition (A2-1) was set at 3.5 pl, the film thickness after filling was set at 28 nm, and the diameter of the droplet at the start timing was set at 100 $\mu$m. The mold thickness was 1 mm. Table 10 shows the calculation results of the filling time.

[Table 10]

| | Comparative Example 14 | Comparative Example 15 | Example 6 |
|---|---|---|---|
| Ambient gas | Helium | Nitrogen | Carbon dioxide |
| Underlayer thickness [nm] | 10 | 10 | 10 |
| Theoretical filling time [s] | 2.31 | 6.55 | 1.3 |
| Found filling time [s] | No data | No data | No data |

It was confirmed by the theoretical calculations that the filling time is short in the carbon dioxide atmosphere.

[Comparative Example 16, Example 7]

In pattern formation in which the thickness of the underlayer was 5 nm, the filling times when using helium, nitrogen, and carbon dioxide as an ambient gas (inner-gap gas) were calculated by inputting the various coefficients described in Tables 1 and 3. The volume of the droplet of the curable composition (A2-1) was set at 3.5 pl, the film thickness after filling was set at 28 nm, and the diameter of the droplet at the start timing was set at 100 $\mu$m. The mold

thickness was 1 mm. Table 11 shows the calculation results of the filling time.

[Table 11]

| | Comparative Example 16 | Example 7 |
|---|---|---|
| Ambient gas | Helium | Carbon dioxide |
| Underlayer thickness [nm] | 5 | 5 |
| Theoretical filling time [s] | 2.5 | 2.2 |
| Found filling time [s] | No data | No data |

It was confirmed by the theoretical calculations that the filling time is short in the carbon dioxide atmosphere.

[Comparative Example 17, Example 8, Example 9, Example 10]

In pattern formation in which the thickness of the underlayer was 50 nm, the filling time when using a gas mixture of nitrogen and carbon dioxide as an ambient gas (inner-gap gas) was calculated. The volume of the droplet was set at 3.5 pl, the film thickness after filling was set at 28 nm, and the diameter of the droplet at the start timing was set at 100 μm.

The mold thickness was 1 mm. Table 12 shows the calculation results of the filling time and the physical property values of the gas mixture.

[Table 12]

| | Example 8 | Example 9 | Example 10 | Comparative Example 17 |
|---|---|---|---|---|
| Gas mixture molar ratio (nitrogen : carbon dioxide) | 25:75 | 50:50 | 75:25 | 90:10 |
| Underlayer thickness [nm] | 50 | 50 | 50 | 50 |
| Solubility coefficient with respect | 0 | 0 | 0 | 0 |
| to mold [kg/m$^3$•atm] | | | | |
| Diffusion coefficient in mold [m$^2$/s] | 0 | 0 | 0 | 0 |
| Solubility coefficient with respect to curable composition [kg/m$^3$•atm] | 1.38 | 0.96 | 0.53 | 0.28 |
| Diffusion coefficient in curable composition [m$^2$/s] | $1.0\times10^{-10}$ | $1.5\times10^{-10}$ | $2.0\times10^{-10}$ | $23\times10^{-10}$ |
| Solubility coefficient with respect to underlayer [kg/m$^3$•atm] | 2.01 | 1.28 | 0.67 | 0.36 |
| Diffusion coefficient in underlayer [m$^2$/s] | $1.48\times10^{-10}$ | $1.65\times10^{-10}$ | $1.83\times10^{-10}$ | $1.93\times10^{-10}$ |
| Theoretical filling time [s] | 0.43 | 0.51 | 0.71 | 1.1 |
| Found filling time [s] | No data | No data | No data | No data |

It was confirmed by the theoretical calculations that the filling time is shorter than 1 s when a gas mixture of nitrogen and carbon dioxide is used as an ambient gas and the molar ratio of carbon dioxide is 25% or more.

[Comparative Example 18, Comparative Example 19, Example 11, Example 12, Example 13, Example 14]

In pattern formation in which the thickness of the underlayer was 50 nm, the filling time when using a gas mixture of oxygen and carbon dioxide as an ambient gas (inner-gap gas) was calculated. The volume of the droplet was set at 3.5 pl, the film thickness after filling was set at 28 nm, and the diameter of the droplet at the start timing was set at 100 μm.

The mold thickness was 1 mm. Table 13 shows the calculation results of the filling time and the physical property values of the gas mixture.

[Table 13]

| | Example 11 | Example 12 | Example 13 | Example 14 | Comparative Example 18 | Comparative Example 19 |
|---|---|---|---|---|---|---|
| Gas mixture molar ratio (oxygen : carbon dioxide) | 20:8 | 25:75 | 50:50 | 75:25 | 90:10 | 100:0 |
| Underlayer thickness [nm] | 50 | 50 | 50 | 50 | 50 | 50 |
| Solubility coefficient with respect to mold [kg/m$^3$•atm] | 0 | 0 | 0 | 0 | 0 | 0 |
| Diffusion coefficient in mold [m$^2$/s] | 0 | 0 | 0 | 0 | 0 | 0 |
| Solubility coefficient with respect to curable composition [kg/m$^3$•atm] | 1.47 | 1.38 | 0.96 | 0.54 | 0.29 | 0.13 |
| Diffusion coefficient in curable composition [m$^2$/s] | $9\times10^{-11}$ | $1.0\times10^{-10}$ | $1.5\times10^{-10}$ | $2.0\times10^{-10}$ | $23\times10^{-10}$ | $2.5\times10^{-10}$ |
| Solubility coefficient with respect to | 2.21 | 2.06 | 1.35 | 0.74 | 0.41 | 0.21 |
| underlayer [kg/m$^3$•atm] | | | | | | |
| Diffusion coefficient in underlayer [m$^2$/s] | $1.39\times10^{-10}$ | $1.41\times10^{-10}$ | $1.53\times10^{-10}$ | $1.64\times10^{-10}$ | $1.71\times10^{-10}$ | $1.75\times10^{-10}$ |
| Theoretical filling time [s] | 0.43 | 0.45 | 0.54 | 0.77 | 1.2 | 2.1 |
| Found filling time [s] | No data | No data | No data | No data | No data | No data |

It was confirmed by the theoretical calculations that the filling time is shorter than 1 s when the molar ratio of carbon dioxide is 25% or more in an atmosphere of a gas mixture of oxygen and carbon dioxide.

<Example of Theoretical Calculation of Filling Time Regarding Planarization>

The filling time in a planarization method using 2,000-nm thick Cytop (manufactured by AGC) as a protective layer of a mold was calculated as follows.

Table 14 collectively shows the diffusion coefficients of gases (helium, nitrogen, and carbon dioxide) in an organic material or a protective layer on the mold surface, the curable composition (A2-2), and a silicon substrate, and the solubility coefficients of the gases with respect to the silicon substrate, necessary for the theoretical calculation of the filling time.

Table 14]

| | Helium | Nitrogen | Carbon dioxide |
|---|---|---|---|
| Solubility coefficient with respect to protective layer [kg/m$^3$•atm] | 0.0018 | 0.15 | 2.36 |
| Diffusion coefficient in protective layer [m$^2$/s] | $1.19\times10^{-8}$ | $5.3\times10^{-11}$ | $1.0\times10^{-10}$ |
| Solubility coefficient with respect to curable composition [kg/m$^3$•atm] | 0.004 | 0.11 | 1.8 |
| Diffusion coefficient in curable composition [m$^2$/s] | $5\times10^{-9}$ | $2.5\times10^{-10}$ | $5\times10^{-11}$ |

(continued)

| | Helium | Nitrogen | Carbon dioxide |
|---|---|---|---|
| Solubility coefficient with respect to silicon substrate [$kg/m^3 \cdot atm$] | 0 | 0 | 0 |
| Diffusion coefficient in silicon substrate [$m^2/s$] | 0 | 0 | 0 |

The bases of the physical property values described in Table 14 will be explained below.

Well-known values were used as the solubility coefficient with respect to the organic material or the protective layer on the mold surface, and as the diffusion coefficient in the organic material or the protective layer on the mold surface.

Values of isobornyl acrylate were used as the solubility coefficient with respect to the curable composition (A2-2) and as the diffusion coefficient in the curable composition, as in Table 3.

The solubility coefficient with respect to the silicon substrate and the diffusion coefficient in the silicon substrate were 0 as in Table 3.

[Comparative Example 20, Comparative Example 21, Example 15]

In planarization in which the thickness of an organic material or a protective layer on the mold surface was 2,000 nm, the filling time was calculated by inputting the various coefficients described in Tables 2 and 14, when using helium, nitrogen, and carbon dioxide as an ambient gas (inner-gap gas). The volume of the droplet of the curable composition (A2-2) was 1 pl, the film thickness after filling was 60 nm, and the diameter of the droplet at the start timing was 100 μm. Table 15 shows the calculated values of the filling time.

[Table 15]

| | Comparative Example 20 | Comparative Example 21 | Example 15 |
|---|---|---|---|
| Ambient gas | Helium | Nitrogen | Carbon dioxide |
| Underlayer thickness [nm] | 2,000 | 2,000 | 2,000 |
| Filling time [s] | 0.05 | 0.34 | 0.05 |

It was confirmed by the theoretical calculations that in a carbon dioxide atmosphere (inner-gap gas = carbon dioxide), the filling time is shorter than that of nitrogen and equivalent to that of helium. In addition, carbon dioxide gas is generally less expensive than helium gas, so the cost of the ambient gas can be reduced without decreasing the throughput as long as the filling time is equal to that of helium.

[Comparative Example 22, Example 16]

The filling time in the pattern forming method of this embodiment was measured by an experiment as follows. FNIS-031A manufactured by FUJIFILM was used as a curable composition (A2-3). ODL-301 manufactured by Shin-Etsu Chemical was used as an underlayer material. 0.6-pL droplets of the curable composition (A2-3) were dropped at a uniform density so that the average liquid film thickness was 32 nm, within a range of 26 × 33 mm on a silicon substrate coated with 200-nm thick ODL-301 as an underlayer, and a quartz blank mold was brought into contact with the droplets by using carbon dioxide or helium as an ambient gas. When a predetermined waiting time elapsed after the contact, the curable composition (A2-3) was cured by emitting ultraviolet light through the mold, and a cured film of the curable composition (A2-3) was obtained by separating the mold. Defective portions deriving from residual air bubbles in the cured film were counted. A waiting time in which the defective portion density was less than 10 portions/$cm^2$ was defined as the filling time.

The defective portion density decreased as the waiting time prolonged in each ambient gas. The filling time when using carbon dioxide was less than 0.7 sec (Example 16), but helium required 0.9 sec (Comparative Example 22).

An article manufacturing method of manufacturing an article by using the abovementioned film forming method or pattern forming method will be explained below. A cured film or the pattern of a cured product formed by the abovementioned film forming method or pattern forming method is used permanently for at least some of various kinds of articles or temporarily when manufacturing various kinds of articles. The articles are an electric circuit element, an optical element, a MEMS, a recording element, a sensor, a mold, and the like. Examples of the electric circuit element are volatile and nonvolatile semiconductor memories such as a DRAM, an SRAM, a flash memory, and an MRAM and semiconductor elements such as an LSI, a CCD, an image sensor, and an FPGA. Examples of the optical element

include a microlens, a light guide, a waveguide, an antireflection film, a diffraction grating, a polarizing element, a color filter, a light emitting element, a display, and a solar cell. Examples of the MEMS include a DMD, a microchannel, and an electromechanical conversion element. Examples of the recording element include an optical disk such as a CD or a DVD, a magnetic disk, a magneto-optical disk, and a magnetic head. Examples of the sensor include a magnetic sensor, an optical sensor, and a gyro sensor. The mold includes an imprint mold or the like.

The pattern of the cured product is directly used as at least some of the constituent members of the above-described articles or used temporarily as a resist mask. After etching or ion implantation is performed in the substrate processing step, the resist mask is removed.

An article manufacturing method in which an imprint apparatus forms a pattern on a substrate, processes the substrate on which the pattern is formed, and manufactures an article from the processed substrate will be described next.

As shown Fig. 5A, a substrate 1z such as a silicon wafer with a processed material 2z such as an insulator formed on the surface is prepared. Next, an imprint material 3z is applied to the surface of the processed material 2z by an inkjet method or the like. A state in which the imprint material 3z is applied as a plurality of droplets onto the substrate is shown here.

As shown in Fig. 5B, a side of a mold 4z for imprint with a concave-convex pattern is directed toward and made to face the imprint material 3z on the substrate. As shown in Fig. 5C, the substrate 1 to which the imprint material 3z is applied is brought into contact with the mold 4z, and a pressure is applied. The gap between the mold 4z and the processed material 2z is filled with the imprint material 3z. In this state, when the imprint material 3z is irradiated with light as energy for curing via the mold 4z, the imprint material 3z is cured.

As shown in Fig. 5D, after the imprint material 3z is cured, the mold 4z is separated from the substrate 1z, and the pattern of the cured product of the imprint material 3z is formed on the substrate 1z. In the pattern of the cured product, the concave portion of the mold corresponds to the convex portion of the cured product, and the convex portion of the mold corresponds to the concave portion of the cured product. That is, the concave-convex pattern of the mold 4z is transferred to the imprint material 3z.

As shown in Fig. 5E, when etching is performed using the pattern of the cured product as an etching resistant mask, a portion of the surface of the processed material 2z where the cured product does not exist or remains thin is removed to form a groove 5z. As shown in Fig. 5F, when the pattern of the cured product is removed, an article with the grooves 5z formed in the surface of the processed material 2z can be obtained. Here, the pattern of the cured product is removed. However, instead of removing the pattern of the cured product after the process, it may be used as, for example, an interlayer dielectric film included in a semiconductor element or the like, that is, a constituent member of an article.

Another article manufacturing method will be described next. As shown Fig. 6A, a substrate 1y such as silica glass is prepared. Next, an imprint material 3y is applied to the surface of the substrate 1y by an inkjet method or the like. A layer of another material such as a metal or a metal compound may be provided on the surface of the substrate 1y.

As shown in Fig. 6B, a side of a mold 4y for imprint with a concave-convex pattern is directed toward and made to face the imprint material 3y on the substrate. As shown in Fig. 6C, the substrate 1y to which the imprint material 3y is applied is brought into contact with the mold 4y, and a pressure is applied. The gap between the mold 4y and the substrate 1y is filled with the imprint material 3y. In this state, when the imprint material 3 is irradiated with light via the mold 4y, the imprint material 3 is cured.

As shown in Fig. 6D, after the imprint material 3y is cured, the mold 4y is separated from the substrate 1y, and the pattern of the cured product of the imprint material 3y is formed on the substrate 1y. Thus, an article including the pattern of the cured product as a constituent member can be obtained. Note that when the substrate 1y is etched using the pattern of the cured product as a mask in the state shown in Fig. 6D, an article with the concave and convex portions reversed with respect to the mold 4y, for example, an imprint mold can be obtained.

Next, an article manufacturing method of manufacturing an article by using the abovementioned film forming method of forming a film having a flat surface will be explained below. This article manufacturing method includes a film forming step of forming a film on a substrate in accordance with the abovementioned film forming method, and a processing step of processing the substrate on which the film is formed, and manufactures an article from the substrate having undergone these steps. The processing step can include a step of forming a photoresist film on the abovementioned film, a step of forming a latent image on the photoresist film by using an exposure apparatus, and a step of forming a photoresist pattern by developing the latent image. This processing step can further include a step of performing processing (for example, etching or ion implantation) on a substrate 1 by using the photoresist pattern.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2020-212772 filed December 22, 2020 and Japanese Patent Application No. 2021-198701 filed December 7, 2021, which are hereby incorporated by reference herein.

## Claims

1. A film forming method of forming a film made of a curable composition, **characterized by** comprising:

   an arranging step of arranging the curable composition on an underlayer of a substrate including a base member and the underlayer arranged on the base member;
   a contact step of bringing the curable composition and a mold into contact with each other after the arranging step;
   a curing step of curing the curable composition after the contact step; and
   a separation step of separating the curable composition and the mold after the curing step,
   wherein a gas filling a space between the underlayer and the mold exists in the contact step, and
   a solubility coefficient of the gas with respect to the underlayer is not less than 0.5 $kg/m^3$•atm and not more than 10 $kg/m^3$•atm.

2. The film forming method according to claim 1, **characterized in that** the underlayer is not less than 5 nm.

3. The film forming method according to claim 1 or 2, **characterized in that** a solubility coefficient of the gas with respect to the curable composition is not more than 10 $kg/m^3$•atm.

4. The film forming method according to any one of claims 1 to 3, **characterized in that** the gas contains carbon dioxide at a molar ratio of not less than 25%.

5. The film forming method according to any one of claims 1 to 4, **characterized in that** the mold has a pattern, and the film on which the pattern is transferred is formed through the contact step, the curing step, and the separation step.

6. The film forming method according to any one of claims 1 to 4, **characterized in that** the mold has a flat surface, and the film having a surface conforming to the flat surface is formed through the contact step, the curing step, and the separation step.

7. A film forming method of forming a film made of a curable composition, **characterized by** comprising:

   an arranging step of arranging the curable composition on an underlayer of a substrate including a base member and the underlayer arranged on the base member;
   a contact step of bringing the curable composition and a mold into contact with each other after the arranging step;
   a curing step of curing the curable composition after the contact step; and
   a separation step of separating the curable composition and the mold after the curing step,
   wherein a gas filling a space between the underlayer and the mold exists in the contact step, and
   letting S [$kg/m^3$•atm] be a solubility coefficient of the gas with respect to the underlayer, and D [$m^2/s$] be a diffusion coefficient of the gas in the underlayer, S•D is not less than $0.5 \times 10^{-10}$ and not more than $10 \times 10^{-10}$.

8. The film forming method according to claim 7, **characterized in that** the underlayer is not less than 5 nm.

9. The film forming method according to claim 7 or 8, **characterized in that** S is not less than 0.5 $kg/m^3$•atm and not more than 10 $kg/m^3$•atm.

10. The film forming method according to any one of claims 7 to 9, **characterized in that** a solubility coefficient of the gas with respect to the curable composition is not more than 10 $kg/m^3$•atm.

11. The film forming method according to any one of claims 7 to 10, **characterized in that** the gas contains carbon dioxide at a molar ratio of not less than 25%.

12. The film forming method according to any one of claims 7 to 11, **characterized in that** the mold has a pattern, and the film on which the pattern is transferred is formed through the contact step, the curing step, and the separation step.

13. The film forming method according to any one of claims 7 to 11, **characterized in that** the mold has a flat surface, and the film having a surface conforming to the flat surface is formed through the contact step, the curing step, and the separation step.

14. A film forming method of forming a film made of a curable composition by using a mold having a surface made of

an organic material, **characterized by** comprising:

an arranging step of arranging the curable composition on a substrate;
a contact step of bringing the curable composition and the surface of the mold into contact with each other after the arranging step;
a curing step of curing the curable composition after the contact step; and
a separation step of separating the curable composition and the mold after the curing step,
wherein a gas filling a space between the substrate and the mold exists in the contact step, and
a solubility coefficient of the gas with respect to the organic material forming the surface of the mold is not less than 0.5 $kg/m^3 \cdot atm$ and not more than 10 $kg/m^3 \cdot atm$.

**15.** The film forming method according to claim 14, **characterized in that** a solubility coefficient of the gas with respect to the curable composition is not more than 10 $kg/m^3 \cdot atm$.

**16.** The film forming method according to claim 14 or 15, **characterized in that** the gas contains carbon dioxide at a molar ratio of not less than 25%.

**17.** The film forming method according to any one of claims 14 to 16, **characterized in that** the mold has a flat surface, and the film having a surface conforming to the flat surface is formed through the contact step, the curing step, and the separation step.

**18.** The film forming method according to any one of claims 14 to 16, **characterized in that** the mold has a pattern, and the film on which the pattern is transferred is formed through the contact step, the curing step, and the separation step.

**19.** A film forming method of forming a film made of a curable composition by using a mold having a surface made of an organic material, **characterized by** comprising:

an arranging step of arranging the curable composition on a substrate;
a contact step of bringing the curable composition and the surface of the mold into contact with each other after the arranging step;
a curing step of curing the curable composition after the contact step; and
a separation step of separating the curable composition and the mold after the curing step,
wherein a gas filling a space between the substrate and the mold exists in the contact step, and
letting S [$kg/m^3 \cdot atm$] be a solubility coefficient of the gas with respect to the organic material, and D [$m^2/s$] be a diffusion coefficient of the gas in the organic material, $S \cdot D$ is not less than $0.5 \times 10^{-10}$ and not more than $10 \times 10^{-10}$.

**20.** The film forming method according to claim 19, **characterized in that** S is not less than 0.5 $kg/m^3 \cdot atm$ and not more than 10 $kg/m^3 \cdot atm$.

**21.** The film forming method according to claim 19 or 20, **characterized in that** a solubility coefficient of the gas with respect to the curable composition is not more than 10 $kg/m^3 \cdot atm$.

**22.** The film forming method according to any one of claims 19 to 21, **characterized in that** the gas contains carbon dioxide at a molar ratio of not less than 25%.

**23.** The film forming method according to any one of claims 19 to 22, **characterized in that** the mold has a flat surface, and the film having a surface conforming to the flat surface is formed through the contact step, the curing step, and the separation step.

**24.** The film forming method according to any one of claims 19 to 22, **characterized in that** the mold has a pattern, and the film on which the pattern is transferred is formed through the contact step, the curing step, and the separation step.

**25.** An article manufacturing method **characterized by** comprising:

a step of forming a film on a substrate by a film forming method defined in any one of claims 1 to 24; and

a step of obtaining an article by processing the substrate on which the film is formed.

FIG. 1

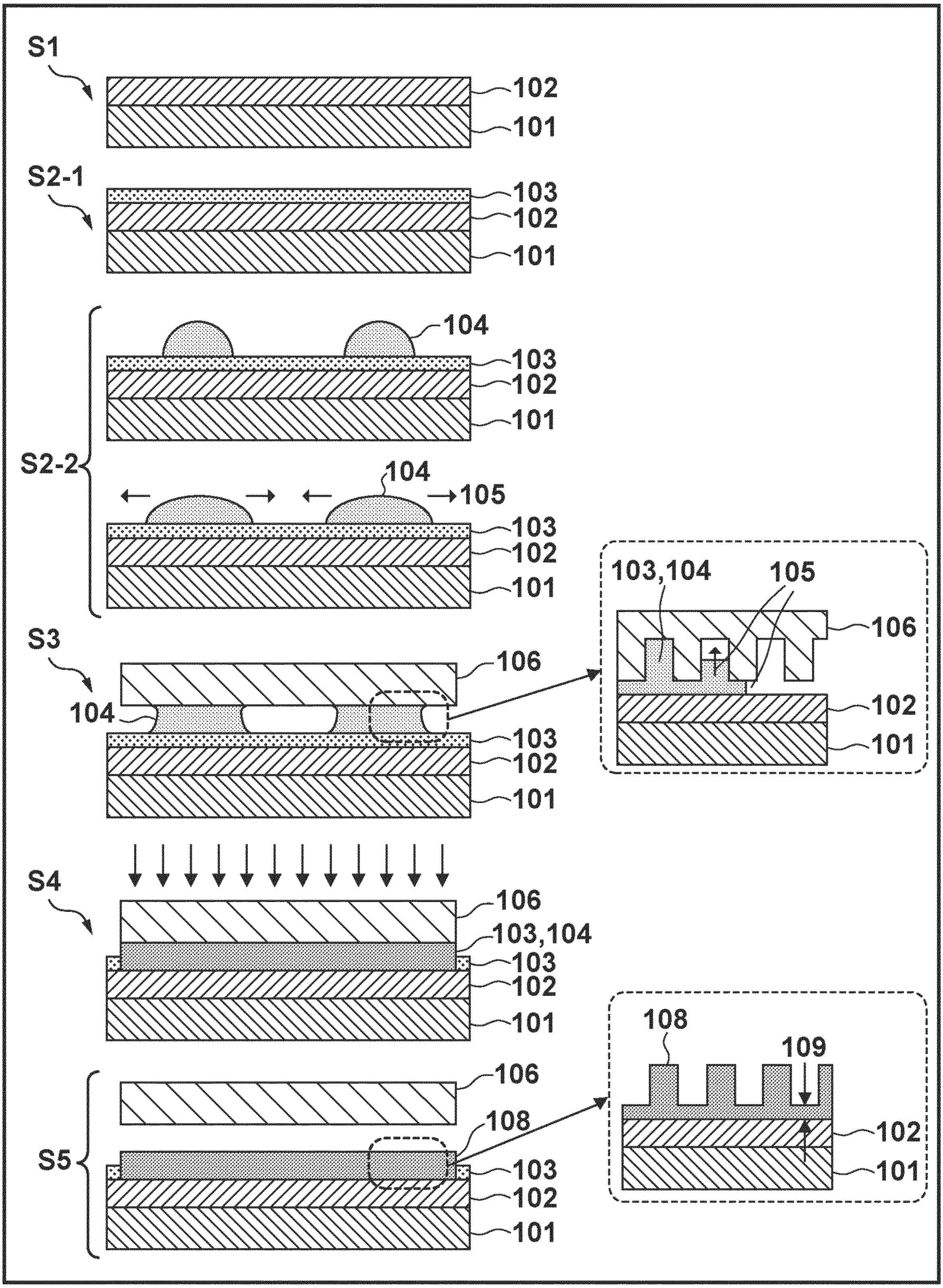
S1
102
101
S2-1
103
102
101
S2-2
104
103
102
101
104
105
103
102
101
103,104
105
106
102
101
S3
106
104
103
102
101
S4
106
103,104
103
102
101
108
109
102
101
S5
106
108
103
102
101

# FIG. 2

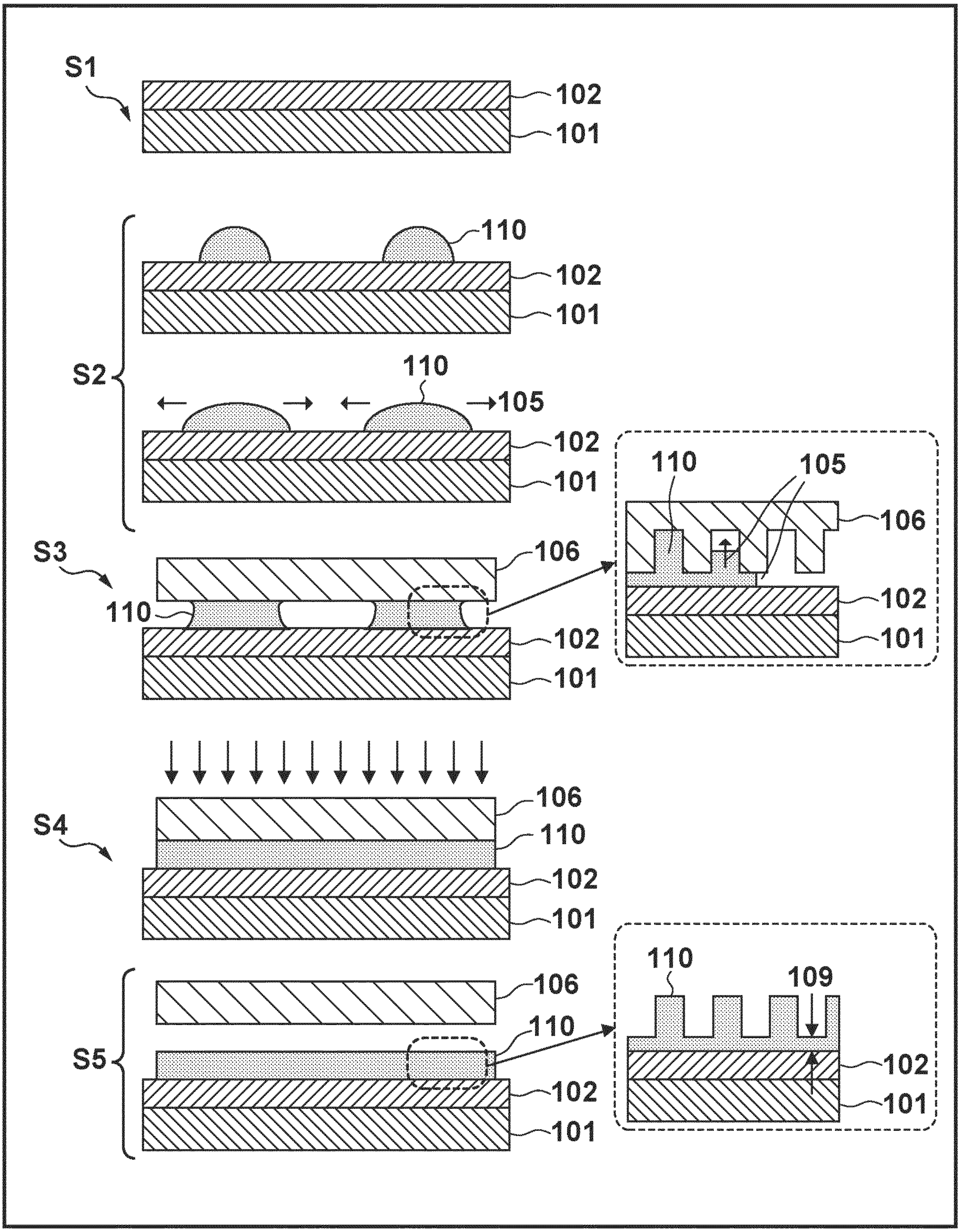
S1
102
101
S2
110
102
101
110
105
102
101
S3
106
110
102
101
110
105
106
102
101
S4
106
110
102
101
S5
106
110
102
101
110
109
102
101

FIG. 3

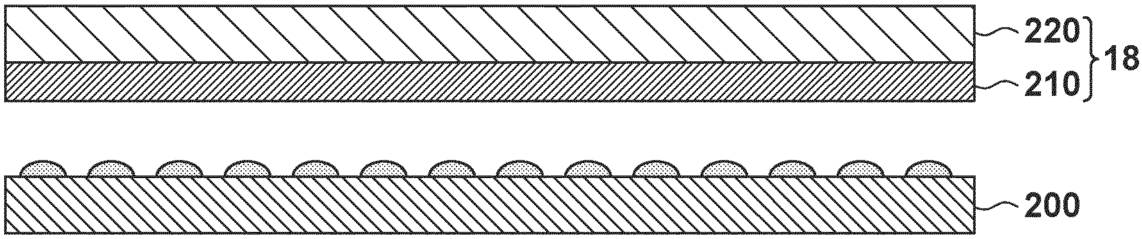


FIG. 4

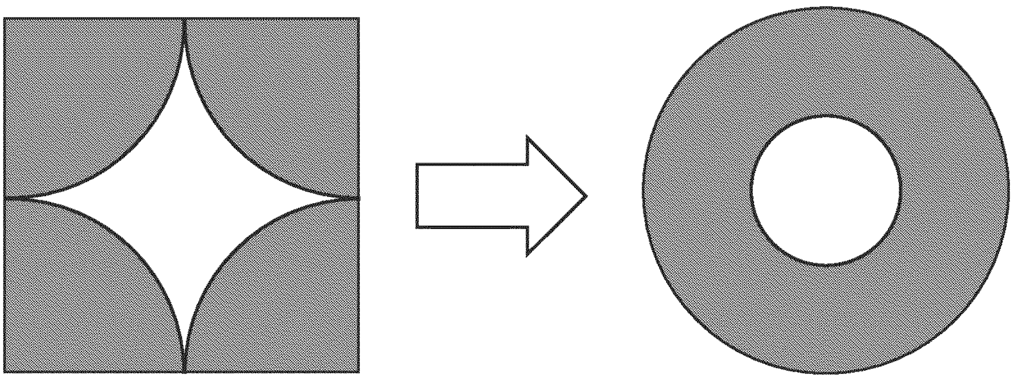

FIG. 5A

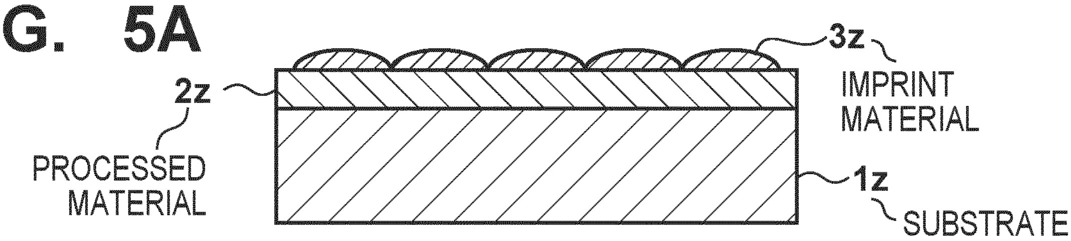


FIG. 5B

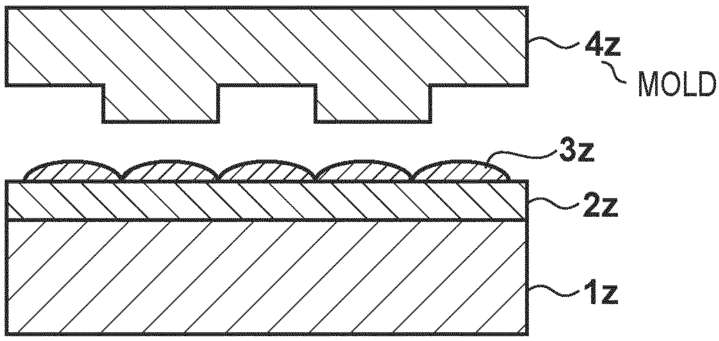


FIG. 5C

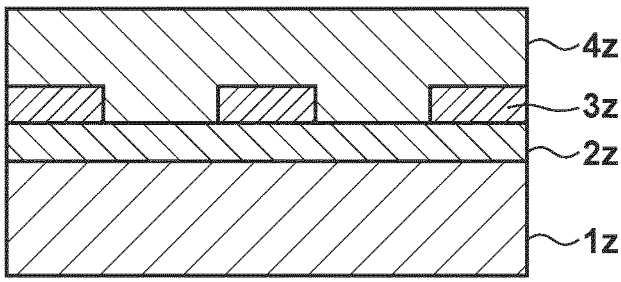


FIG. 5D

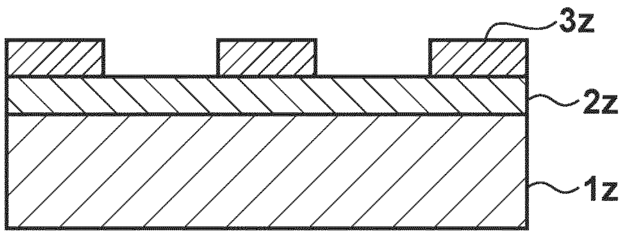


FIG. 5E

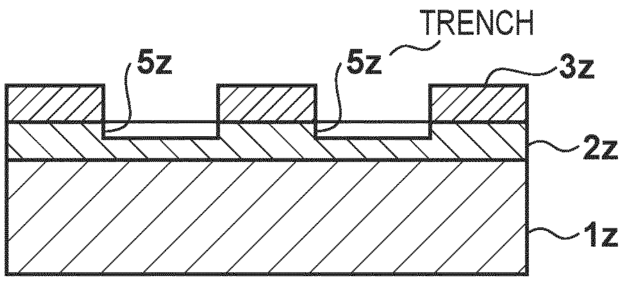


FIG. 5F

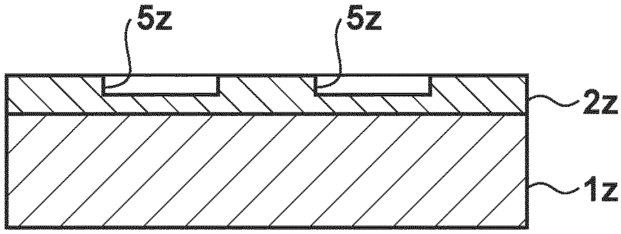

FIG. 6A

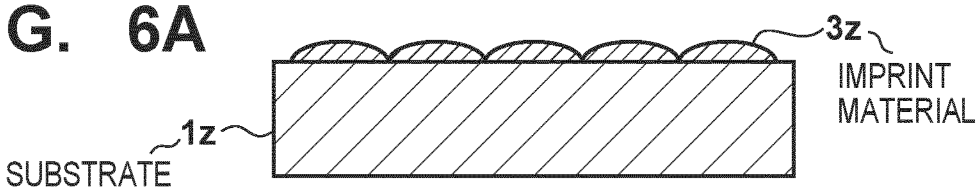


FIG. 6B

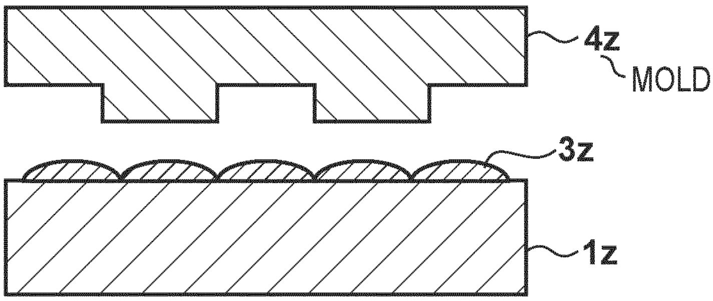


FIG. 6C

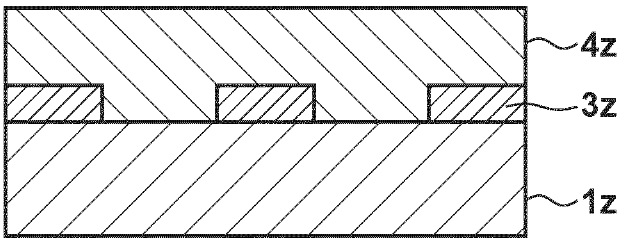


FIG. 6D

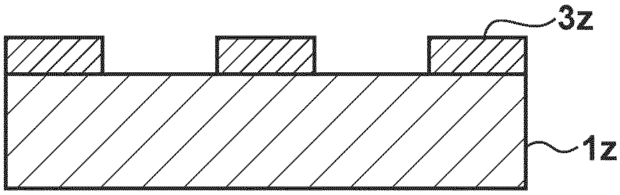

## INTERNATIONAL SEARCH REPORT

International application No.
**PCT/JP2021/046063**

**A. CLASSIFICATION OF SUBJECT MATTER**

***H01L 21/027***(2006.01)i; ***B29C 59/02***(2006.01)i
FI: H01L21/30 502D; B29C59/02 Z

According to International Patent Classification (IPC) or to both national classification and IPC

**B. FIELDS SEARCHED**

Minimum documentation searched (classification system followed by classification symbols)

H01L21/027; B29C59/02

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2012-507140 A (MOLECULAR IMPRINTS, INC.) 22 March 2012 (2012-03-22) paragraphs [0029]-[0033], fig. 1-3 | 1-25 |
| A | JP 2012-992 A (TOSHIBA CORP.) 05 January 2012 (2012-01-05) paragraphs [0037]-[0042], fig. 7, 8 | 1-25 |
| A | JP 2011-41938 A (FUJIFILM CORP.) 03 March 2011 (2011-03-03) paragraph [0002] | 1-25 |
| A | JP 2011-505270 A (MOLECULAR IMPRINTS, INC.) 24 February 2011 (2011-02-24) paragraphs [0032]-[0036], fig. 1-3 | 1-25 |
| A | JP 2003-222592 A (PRESIDENT OF KYOTO UNIVERSITY) 08 August 2003 (2003-08-08) paragraphs [0002]-[0055], fig. 1-5 | 1-25 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 January 2022** | **15 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/046063**

| Patent document cited in search report | Publication date (day/month/year) | Patent family member(s) | Publication date (day/month/year) |
|---|---|---|---|
| JP 2012-507140 A | 22 March 2012 | US 2010/0104852 A1<br>paragraphs [0052]-[0056], fig. 1-3<br>WO 2010/047821 A1<br>TW 201024077 A | |
| JP 2012-992 A | 05 January 2012 | (Family: none) | |
| JP 2011-41938 A | 03 March 2011 | WO 2011/010676 A1 | |
| JP 2011-505270 A | 24 February 2011 | US 2009/0140458 A1<br>paragraphs [0032]-[0036], fig. 1-3<br>WO 2009/067241 A1<br>KR 10-2010-0087327 A<br>CN 101868760 A<br>SG 185929 A<br>TW 200931174 A | |
| JP 2003-222592 A | 08 August 2003 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5065058 B
- JP 2016162862 A
- JP 5827180 B
- JP 2019140394 A
- US 20200286740 A
- JP 2009503139 A
- JP 2020212772 A
- JP 2021198701 A

### Non-patent literature cited in the description

- **N. SHIRAISHI.** *Int. J. Microgravity Sci.,* 2014, (31), S5-S12
- *Proc. SPIE,* 2020, 11324-11
- **SUSUMU OKAZAKI.** Basis of Computer Simulation. *KAGAKUDOJIN,* 2000
- **B. H. BESLER ; K. M. MERZ JR. ; P. A. KOLLMAN.** *J. Comp. Chem.,* 1990, vol. 11, 431
- **U. C. SINGH ; P. A. KOLLMAN.** *J. Comp. Chem.,* 1984, vol. 5, 129